(19) Europäisches Patentamt / European Patent Office / Office européen des brevets

(11) **EP 3 690 966 B1**

(12) **EUROPEAN PATENT SPECIFICATION**

(45) Date of publication and mention of the grant of the patent:
**02.04.2025 Bulletin 2025/14**

(21) Application number: **18860375.7**

(22) Date of filing: **18.09.2018**

(51) International Patent Classification (IPC):
*H10N 10/01* $^{(2023.01)}$      *H10N 10/817* $^{(2023.01)}$
*H10N 10/17* $^{(2023.01)}$

(52) Cooperative Patent Classification (CPC):
**H10N 10/817; H10N 10/01**

(86) International application number:
**PCT/KR2018/010984**

(87) International publication number:
**WO 2019/066354 (04.04.2019 Gazette 2019/14)**

(54) **THERMOELECTRIC DEVICE**

THERMOELEKTRISCHE VORRICHTUNG

DISPOSITIF THERMOÉLECTRIQUE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **26.09.2017   KR 20170124373**
**16.10.2017   KR 20170133852**

(43) Date of publication of application:
**05.08.2020   Bulletin 2020/32**

(73) Proprietor: **LG Innotek Co., Ltd.**
**Seoul 07796 (KR)**

(72) Inventors:
• **JIN, Hee Yol**
**Seoul 07796 (KR)**
• **KIM, Jong Hyun**
**Seoul 07796 (KR)**
• **YANG, Tae Su**
**Seoul 07796 (KR)**
• **YOO, Young Sam**
**Seoul 07796 (KR)**
• **LEE, Gu**
**Seoul 07796 (KR)**
• **LEE, Youn Gyo**
**Seoul 07796 (KR)**
• **JUN, Kye Soo**
**Seoul 07796 (KR)**

(74) Representative: **DREISS Patentanwälte PartG mbB**
**Friedrichstraße 6**
**70174 Stuttgart (DE)**

(56) References cited:
JP-A- 2017 168 609     KR-A- 20110 119 334
KR-A- 20120 071 594     KR-A- 20120 081 777
KR-A- 20120 081 777     KR-B1- 101 773 869
US-A1- 2006 180 191     US-A1- 2012 167 937

## Description

[Technical Field]

The present invention relates to a thermoelectric device, and more specifically, to a thermoelectric device and an electrode structure thereof.

[Background Art]

KR 2012 0081777 A discloses a thermoelectric device according to the preamble of claim 1. US 2012/167937 A1 discloses a thermoelectric module, which includes a first and a second substrates, plural thermoelectric elements, plural first and second metal electrodes, plural first and second solder layers, and spacers.

A thermoelectric phenomenon is a phenomenon which occurs due to movement of an electron and a hole in a material and refers to direct energy conversion between heat and electricity.

The thermoelectric device is a generic term for a device using a thermoelectric phenomenon and has a structure in which a P-type thermoelectric material and an N-type thermoelectric material are bonded between metal electrodes to form a PN junction pair.

The thermoelectric device may be classified into a device using a temperature change of an electrical resistance, a device using a Seebeck effect which is a phenomenon in which an electromotive force is generated by a temperature difference, and a device using a Peltier effect which is a phenomenon in which heat absorption or heat generation occurs due to currents.

Thermoelectric devices have been variously applied to home appliances, electronic components, communication components, and the like. For example, the thermoelectric device may be applied to a cooling device, a heating device, a power generating device, or the like. Accordingly, demands for thermoelectric performance of the thermoelectric device are further increased.

The thermoelectric device includes a substrate, an electrode, and thermoelectric legs, and a plurality of thermoelectric legs are arranged in an array shape between an upper substrate and a lower substrate, and a plurality of upper electrodes and a plurality of plurality of lower electrodes are disposed between the upper substrate and the plurality of thermoelectric legs and between the lower substrate and the plurality of thermoelectric legs, respectively. Here, the upper electrodes and the lower electrodes serially connect the thermoelectric legs.

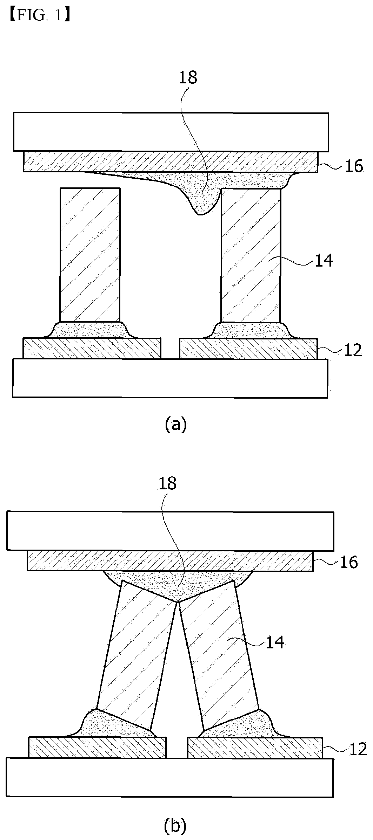

The thermoelectric device may be assembled by a surface mount technology (SMT) which arranges thermoelectric legs in an array shape on a substrate on which a plurality of electrodes are disposed and then goes through a reflow process. Generally, a space between the lower electrodes and the thermoelectric legs and a space between the upper electrodes and the thermoelectric legs may be bonded by solder. FIG. 1 is a view illustrating a problem which can occur when the thermoelectric device is assembled by the SMT. Referring to FIGS. 1A and 1B, the solder may be partially melted through the reflow process. In this case, there is no problem in arrangement between lower electrodes 12 and thermoelectric legs 14, but a solder 18 at upper electrodes 16 is partially driven down by gravity. Accordingly, as shown in FIG. 1A, since a space in which the solder 18 is not disposed is formed between the thermoelectric legs 14 and the electrodes 16, the thermoelectric legs 14 and the electrodes 16 cannot be bonded to each other, or as shown in FIG. 1B, since the solder 18 is driven to a center, a short circuit can be generated between a pair of thermoelectric legs 14.

Meanwhile, generally, a space between the upper substrate and the upper electrodes and a space between the lower substrate and the lower electrodes may be directly bonded or adhered by an adhesion layer. When the space between the upper substrate and the upper electrodes and the space between the lower substrate and the lower electrodes are directly bonded, it is advantageous in terms of thermal conductivity in comparison with the case in which adhesion is performed by the adhesion layer, but there is a problem in that reliability is inferior due to a large thermal expansion coefficient difference between the substrate and the electrodes. Meanwhile, when the space between the upper substrate and the upper electrodes and the space between the lower substrate and the lower electrodes are adhered by the adhesion layer, the adhesion layer is deteriorated during the reflow process and thus the electrodes can be separated from the substrate.

[Disclosure]

[Technical Problem]

The present invention is directed to providing an electrode structure of a thermoelectric device.

[Technical Solution]

One aspect of the present invention provides a thermoelectric device including a first substrate, a plurality of P-type thermoelectric legs and a plurality of N-type thermoelectric legs alternately disposed on the first substrate, a second substrate disposed on the plurality of P-type thermoelectric legs and the plurality of N-type thermoelectric legs, a plurality of first electrodes disposed between the first substrate and the plurality of P-type thermoelectric legs and the plurality of N-type thermoelectric legs and respectively having a pair of P-type thermoelectric leg and N-type thermoelectric leg disposed therein, and a plurality of second electrodes disposed between the second substrate and the plurality of P-type thermoelectric legs and the plurality of N-type thermoelectric legs and respectively having a pair of P-type thermoelectric leg and N-type thermoelectric leg disposed therein, wherein a pair of P-type solder layer and N-type solder layer and a barrier layer disposed between the pair of P-type solder layer and N-type solder layer are disposed on each of the plurality of first electrodes, a pair of P-type solder layer and N-type solder layer and a barrier layer disposed between the pair of P-type solder layer and N-type solder layer are disposed on each of the plurality of second electrodes, each of the P-type thermoelectric legs directly comes into contact with each of the P-type solder layers, each of the N-type thermoelectric legs directly comes into contact with each of the N-type solder layers, and a melting point of the barrier layer is greater than a melting point of each of the pair of P-type solder layer and N-type solder layer. The barrier layer has an insulation property. An adhesive resin layer is further provided between the first substrate and the plurality of first electrodes.

A height of the barrier layer may be greater than a height of each of the pair of P-type solder layer and N-type solder layer.

Side surfaces of the barrier layer may come into contact with the pair of P-type solder layer and N-type solder layer.

The barrier layer may include a first region having a first height, and a second region having a second height which is lower than the first height, at least a portion of the first region may come into contact with a side surface of each of the pair of P-type solder layer and N-type solder layer, and the second region may be surrounded by the first region.

The first height may be 1.01 to 1.2 times the second height.

An area of the first region may be 0.01% to 10% of an entire area of the barrier layer.

The barrier layer may include an epoxy resin.

A plated layer may be further disposed on each of the plurality of first electrodes and the plurality of second electrodes.

The plated layer may include tin.

The barrier layer may be directly adhered onto the plated layer.

Another embodiment does not form part of the present invention but represents background art that is useful for understanding the invention. This embodiment provides a thermoelectric device including a first substrate in which a plurality of first grooves are formed in an edge thereof, a plurality of P-type thermoelectric legs and a plurality of N-type thermoelectric legs alternately disposed on the first substrate, a second substrate disposed on the plurality of P-type thermoelectric legs and the plurality of N-type thermoelectric legs, a plurality of first electrodes disposed between the first substrate and the plurality of P-type thermoelectric legs and the plurality of N-type thermoelectric legs and respectively having a pair of P-type thermoelectric leg and N-type thermoelectric leg disposed therein, a plurality of second electrodes disposed between the second substrate and the plurality of P-type thermoelectric legs and the plurality of N-type thermoelectric legs and respectively having a pair of P-type thermoelectric leg and N-type thermoelectric leg disposed therein, and an electrode fixing member configured to fix the first substrate and the plurality of first electrodes, wherein the electrode fixing member includes a plurality of first lines disposed in a first direction, a plurality of second lines disposed in a second direction crossing the first direction, and third lines configured to extend in a direction perpendicular to the plurality of first lines and the plurality of second lines at both ends of the plurality of first lines and both ends of the plurality of second lines to be inserted into the plurality of first grooves, and each of at least some of the plurality of first lines is disposed between the pair of P-type thermoelectric leg and N-type thermoelectric leg on the plurality of first electrodes.

Each of the at least some of the plurality of first lines may be disposed to be in close contact with the plurality of first electrodes at a space between the pair of P-type thermoelectric leg and N-type thermoelectric leg.

At least some of the plurality of second lines may be disposed on an adhesion layer at spaces between the plurality of first electrodes.

A plurality of second grooves may be formed in at least some of points spaced apart from the plurality of first grooves on the first substrate at predetermined intervals, and the electrode fixing member may further include fourth lines configured to extend in the direction perpendicular to the plurality of first lines and the plurality of second lines from points spaced apart from both ends of the plurality of first lines at the predetermined intervals to be inserted into the plurality of second grooves.

A depth of each of the plurality of first grooves may be 0.1 to 0.9 times a height of the first substrate.

At least some of the plurality of first grooves may be filled with the third line and adhesives.

The electrode fixing member may be formed of an insulating material.

Still another embodiment does not form part of the present invention but represents background art that is useful for understanding the invention. This embodiment provides a thermoelectric device including a first substrate in which a plurality of first grooves are formed in an edge thereof, a plurality of P-type thermoelectric legs and a plurality of N-type thermoelectric legs alternately disposed on the first substrate, a second substrate disposed on the plurality of P-type thermoelectric legs and the plurality of N-type thermoelectric legs, a plurality of first electrodes disposed between the first substrate and the plurality of P-type thermoelectric legs and the plurality of N-type thermoelectric legs and respectively having a pair of P-type thermoelectric leg and N-type thermoelectric leg disposed therein, a plurality of second electrodes disposed between the second substrate and the plurality of P-type thermoelectric legs and the plurality of N-type thermoelectric legs and respectively having a pair of P-type thermoelectric leg and N-type thermoelectric leg disposed therein, and an electrode fixing member configured to fix the first substrate and the plurality of first electrodes, wherein the electrode fixing member includes a plurality of first lines disposed in a first direction, a plurality of second lines disposed in a second direction crossing the plurality of first lines and forming a plurality of openings, and third lines configured to extend in a direction perpendicular to the plurality of first lines and the plurality of second lines at both ends of the plurality of first lines and both ends of the plurality of second lines to be inserted into the plurality of first grooves, at least some of the plurality of first lines are disposed on the plurality of first electrodes, and the P-type thermoelectric leg disposed on one first electrode and the N-type thermoelectric leg disposed on another first electrode adjacent to the one first electrode are disposed in each of the openings.

Two first lines forming each of the openings may be disposed to be in close contact with the plurality of first electrodes, and two second lines may be disposed between the plurality of first electrodes.

[Advantageous Effects]

According to an embodiment of the present invention, a thermoelectric device having excellent performance can be obtained. Specifically, according to the embodiment of the present invention, defects generated during a reflow process for assembling the thermoelectric device can be reduced. Further, according to the embodiment of the present invention, adhesion between electrodes and legs can be improved, and a short circuit between the thermoelectric legs due to movement of a solder can be prevented.

Further, according to the embodiment of the present invention, a thermoelectric device having excellent heat conductivity and high reliability and in which a substrate and electrodes are solidly fixed can be obtained. Accordingly, even when adhesion between the electrodes and the substrate is weakened during a high-temperature reflow process or a wiring work, separation of the electrodes from the substrate can be prevented.

[Description of Drawings]

FIG. 1 is a view illustrating a problem which may occur when the thermoelectric device is assembled by a surface mount technology (SMT).
FIG. 2 is a cross-sectional view of the thermoelectric device, and FIG. 3 is a perspective view of the thermoelectric device.
FIG. 4 is a cross-sectional view of a thermoelectric device according to one embodiment of the present invention.
FIG. 5 is a plan view of a substrate and an electrode structure of the thermoelectric device according to one embodiment of the present invention.

FIG. 6 is a flow chart illustrating a method of manufacturing the thermoelectric device according to one embodiment of the present invention.
FIG. 7 is a photograph illustrating a region in which a plurality of electrodes are disposed on the substrate and then a barrier layer is printed.
FIG. 8 is a cross-sectional view of a portion of the thermoelectric device according to one embodiment of the present invention.
FIGS. 9 to 11 are cross-sectional views of a portion of a thermoelectric device according to another embodiment of the present invention.
FIG. 12 is a view illustrating an example of a substrate and an electrode structure included in the thermoelectric device, and FIG. 13 is a cross-sectional view of FIG. 12.
FIG. 14 is a top view in which an electrode fixing member is fixed on a lower substrate and lower electrodes of the thermoelectric device according to one embodiment of the present invention.
FIG. 15 is a top view of the lower substrate and the lower electrodes of the thermoelectric device according to one embodiment of the present invention.
FIG. 16 is a perspective view of an electrode fixing member according to one embodiment of the present invention.
FIG. 17 is a cross-sectional view taken along line Y1 in FIG. 14.
FIG. 18 is a cross-sectional view taken along line Y2 in FIG. 14.
FIG. 19 is a cross-sectional view taken along line X1 in FIG. 14.
FIG. 20 is a flow chart illustrating a method of disposing the substrate and the electrode of the thermoelectric device according to the embodiment of the present invention.
FIG. 21 is a block diagram of a water purifier to which the thermoelectric device according to the embodiment of the present invention is applied.
FIG. 22 is a block diagram of a refrigerator to which the thermoelectric device according to the embodiment of the present invention is applied.

[Modes of the Invention]

Hereinafter, preferable embodiments of the present invention will be described in detail with reference to the accompanying drawings.
Further, terms used in the embodiments of the present invention (including technical and scientific terms), may be interpreted with meanings that are generally understood by those skilled in the art unless particularly defined and described, and terms which are generally used, such as terms defined in a dictionary, may be understood in consideration of their contextual meanings in the related art.
In addition, terms used in the description are provided not to limit the present invention but to describe the embodiments.

In the specification, the singular form may also include the plural form unless the context clearly indicates otherwise and may include one or more of all possible combinations of A, B, and C when disclosed as at least one (or one or more) of "A, B, and C".

In addition, terms such as first, second, A, B, (a), (b), and the like may be used to describe elements of the embodiments of the present invention.

The terms are only provided to distinguish the elements from other elements, and the essence, sequence, order, or the like of the elements are not limited by the terms.

Further, when particular elements are disclosed as being "connected," "coupled," or "linked" to other elements, the elements may include not only a case of being directly connected, coupled, or linked to other elements but also a case of being connected, coupled, or linked to other elements by elements between the elements and other elements.

In addition, when one element is disclosed as being formed "on or under" another element, the term "on or under" includes both a case in which the two elements are in direct contact with each other and a case in which at least another element is disposed between the two elements (indirectly). Further, when the term "on or under" is expressed, a meaning of not only an upward direction but also a downward direction may be included with respect to one element.

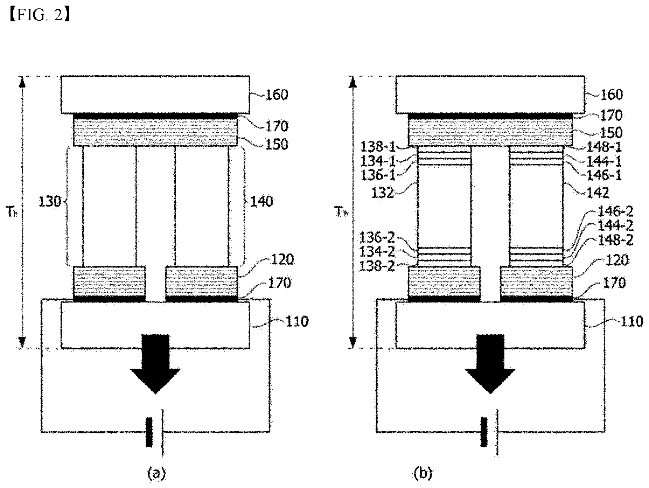

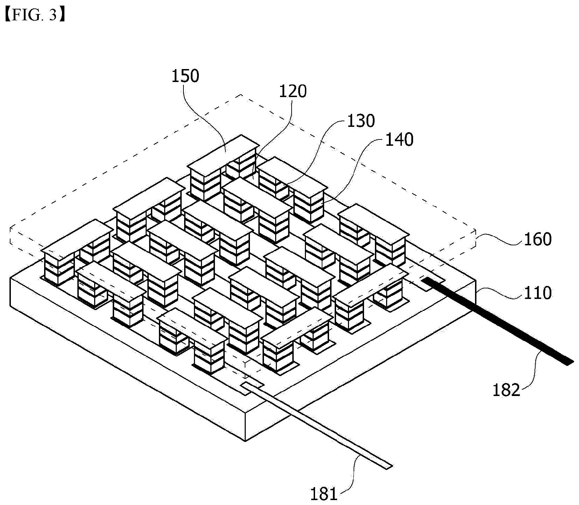

FIG. 2 is a cross-sectional view of the thermoelectric device, and FIG. 3 is a perspective view of the thermoelectric device.

Referring to FIGS. 2 and 3, a thermoelectric device 100 includes a lower substrate 110, lower electrodes 120, P-type thermoelectric legs 130, N-type thermoelectric legs 140, upper electrodes 150, and an upper substrate 160.

The lower electrodes 120 are disposed between the lower substrate 110 and lower surfaces of the P-type thermoelectric legs 130 and the N-type thermoelectric legs 140, and the upper electrodes 150 are disposed between the upper substrate 160 and upper surfaces of the P-type thermoelectric legs 130 and the N-type thermoelectric legs 140. Accordingly, the plurality of P-type thermoelectric legs 130 and the plurality of N-type thermoelectric legs 140 are electrically connected to each other by the lower electrodes 120 and the upper electrodes 150. The pair of P-type thermoelectric leg 130 and N-type thermoelectric leg 140 which are disposed between the lower electrodes 120 and the upper electrodes 150 and electrically connected to each other may form a unit cell.

For example, when a voltage is applied to the lower electrodes 120 and the upper electrodes 150 through lead lines 181 and 182, due to a Peltier effect, the substrate in which current flows from the P-type thermoelectric leg 130 to the N-type thermoelectric leg 140 absorbs heat and thus may act as a cooling part, and the substrate in which current flows from the N-type thermoelectric legs 140 to the P-type thermoelectric legs 130 is heated and thus may act as a heating part.

Here, the P-type thermoelectric legs 130 and the N-type thermoelectric legs 140 may be bismuth telluride (Bi-Te)-based thermoelectric legs including bismuth (Bi) and tellurium (Te) as main raw materials. The P-type thermoelectric leg 130 may be a thermoelectric leg including a bismuth telluride (Bi-Te)-based main raw material of 99 to 99.999 wt% including at least one among antimony (Sb), nickel (Ni), aluminum(Al), copper (Cu), silver (Ag), lead (Pb), boron (B), gallium (Ga), tellurium (Te), bismuth (Bi), and indium (In) and a compound of 0.001 to 1 wt% including bismuth (Bi) or tellurium (Te) on the basis of a total weight of 100 wt%. For example, the main raw material may be bismuth-selenium-tellurium (Bi-Se-Te) and may further include bismuth (Bi) or tellurium (Te) at 0.001 to 1 wt% of the total weight. The N-type thermoelectric leg 140 may be a thermoelectric leg including a bismuth telluride (Bi-Te)-based main raw material of 99 to 99.999 wt% including at least one among selenium (Se), nickel (Ni), aluminum (Al), copper (Cu), silver (Ag), lead (Pb), boron (B), gallium (Ga), tellurium (Te), bismuth (Bi), and indium (In) and a compound of 0.001 to 1 wt% including bismuth (Bi) or tellurium (Te) on the basis of a total weight of 100 wt%. For example, the main raw material may be bismuth-antimony-tellurium (Bi-Sb-Te) and may further include bismuth (Bi) or tellurium (Te) at 0.001 to 1 wt% of the total weight.

Each of the P-type thermoelectric leg 130 and the N-type thermoelectric leg 140 may be formed as a bulk type or a stacked type. Generally, the bulk type P-type thermoelectric leg 130 or the bulk type N-type thermoelectric leg 140 may be obtained by a process of performing heat-treatment on a thermoelectric material to manufacture an ingot, pulverizing and sieving the ingot to obtain powder for thermoelectric legs, and then sintering the powder and cutting a sintered body. The stacked type P-type thermoelectric legs 130 or the stacked type N-type thermoelectric legs 140 may be obtained by a process of coating paste including the thermoelectric material on a sheet-shaped base material to form a unit member and then stacking and cutting the unit material.

In this case, the pair of P-type thermoelectric leg 130 and N-type thermoelectric leg 140 may have the same shape and volume or different shapes and volumes. For example, since electrical conduction characteristics of the P-type thermoelectric leg 130 and the N-type thermoelectric leg 140 are different, a height or cross-sectional area of the N-type thermoelectric leg 140 may be formed to be different from a height or cross-sectional area of the P-type thermoelectric leg 130.

The performance of the thermoelectric device according to one embodiment of the present invention may be shown by the Seebeck index. The Seebeck index (ZT) may be shown as Formula 1.

【Formula 1】

$$ZT = \alpha^2 \sigma T / k$$

Here, $\alpha$ is the Seebeck coefficient [V/K], $\sigma$ is electrical conductivity [S/m], and $\alpha^2\sigma$ is a power factor [W/mK$^2$]. Further, T is a temperature and k is thermal conductivity [W/mK]. k may be shown as $a \cdot c_p \cdot \rho$, a is thermal diffusivity [cm$^2$/S], cp is specific heat [J/gK], and $\rho$ is density [g/cm$^3$].

In order to obtain the Seebeck index of the thermoelectric device, a Z value (V/K) may be measured using a Z meter, and the Seebeck index (ZT) may be calculated using the measured Z value.

According to another embodiment of the present invention, each of a P-type thermoelectric leg 130 and an N-type thermoelectric leg 140 may have a structure shown in FIG. 2B. Referring to FIG. 2B, the thermoelectric legs 130 and 140 include thermoelectric material layers 132 and 142, first plated layers 134-1 and 144-1 respectively stacked on one surfaces of the thermoelectric material layers 132 and 142, second plated layers 134-2 and 144-2 stacked on other surfaces disposed to face the one surfaces of the thermoelectric material layers 132 and 142, first bonding layers 136-1 and 146-1 disposed between the thermoelectric material layers 132 and 142 and the first plated layers 134-1 and 144-1 and second bonding layers 136-2 and 146-2 disposed between the thermoelectric material layers 132 and 142 and the second plated layers 134-2 and 144-2, and first metal layers 138-1 and 148-1 stacked on the first plated layers 134-1 and 144-1 and second metal layers 138-2 and 148-2 stacked on the second plated layers 134-2 and 144-2.

In this case, the thermoelectric material layers 132 and 142 and the first bonding layers 136-1 and 146-1 may directly come into contact with each other, and the thermoelectric material layers 132 and 142 and the second bonding layers 136-2 and 146-2 may directly come into contact with each other. Further, the first bonding layers 136-1 and 146-1 and the first plated layers 134-1 and 144-1 may directly come into contact with each other, and the second bonding layers 136-2 and 146-2 and the second plated layers 134-2 and 144-2 may directly come into contact with each other. In addition, the first plated layers 134-1 and 144-1 and the first metal layer 138-1 and 148-1 may directly come into contact with each other, and the second plated layers 134-2 and 144-2 and the second metal layers 138-2 and 148-2 may directly come into contact with each other.

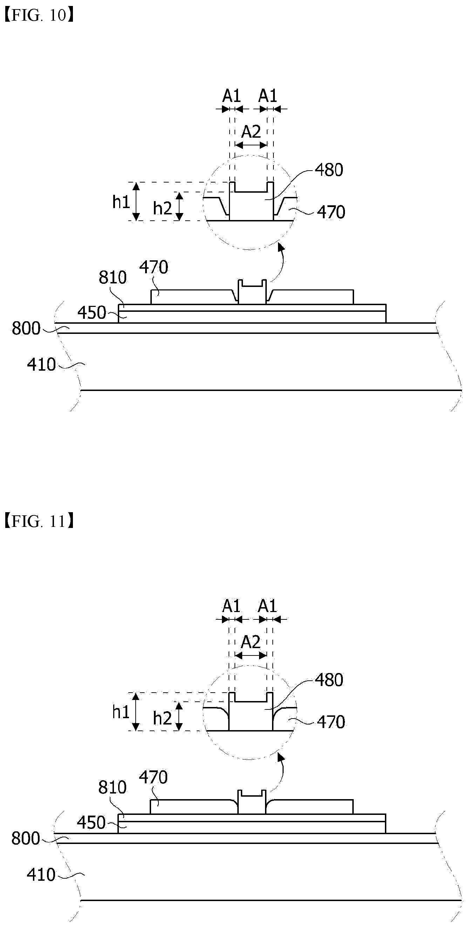

Here, each of the thermoelectric material layers 132 and 142 may include bismuth (Bi) and tellurium (Te) which are semiconductor materials. The thermoelectric material layers 132 and 142 may be formed of a material or have a shape the same as that of the P-type thermoelectric leg 130 or N-type thermoelectric leg 140 shown in FIG. 10A.

Further, the first metal layers 138-1 and 148-1 and the second metal layers 138-2 and 148-2 may each be selected from copper (Cu), a copper alloy, aluminum (Al), and an aluminum alloy, and may each have a thickness of 0.1 to 0.5 mm, and preferably, 0.2 to 0.3 mm. Since a thermal expansion coefficient of each of the first metal layers 138-1 and 148-1 and the second metal layers 138-2 and 148-2 is greater than or similar to a thermal expansion coefficient of each of the thermoelectric material layers 132 and 142, during sintering, a compression stress is applied at an interface between the first metal layers 138-1 and 148-1 and the second metal layers 138-2 and 148-2 and the thermoelectric material layers 132 and 142, and thus cracks or peeling may be prevented. Further, since a coupling force between the first metal layers 138-1 and 148-1 and the second metal layers 138-2 and 148-2 and the electrodes 120 and 150 is high, the thermoelectric legs 130 and 140 may be stably coupled to the electrodes 120 and 150.

In addition, each of the first plated layers 134-1 and 144-1 and the second plated layers 134-2 and 144-2 may include at least one among Ni, Sn, Ti, Fe, Sb, Cr, and Mo and may have a thickness of 1 to 20 $\mu$m, and preferably, 1 to 10 $\mu$m. Since the first plated layers 134-1 and 144-1 and the second plated layers 134-2 and 144-2 prevent a reaction between Bi or Te which are the semiconductor materials of the thermoelectric material layers 132 and 142 and the first metal layers 138-1 and 148-1 and the second metal layers 138-2 and 148-2, the performance degradation of the thermoelectric device may be prevented, and oxidization of the first metal layers 138-1 and 148-1 and the second metal layers 138-2 and 148-2 may also be prevented.

In this case, the first bonding layers 136-1 and 146-1 may be disposed between the thermoelectric material layers 132 and 142 and the first plated layers 134-1 and 144-1 and the second bonding layers 136-2 and 146-2 may be disposed between the thermoelectric material layers 132 and 142 and the second plated layers 134-2 and 144-2. In this case, each of the first bonding layers 136-1 and 146-1 and the second bonding layers 136-2 and 146-2 may include Te. For example, each of the first bonding layers 136-1 and 146-1 and the second bonding layers 136-2 and 146-2 may include at least one among Ni-Te, Sn-Te, Ti-Te, Fe-Te, Sb-Te, Cr-Te and Mo-Te. According to the embodiment of the present invention, a thickness of each of the first bonding layers 136-1 and 146-1 and the second bonding layers 136-2 and 146-2 may be 0.5 to 100 $\mu$m, and preferably, 1 to 50 $\mu$m. According to the embodiment of the present invention, the first bonding layers 136-1 and 146-1 and second bonding layers 136-2 and 146-2 including Te may be disposed between the thermoelectric material layers 132 and 142 and the first plated layers 134-1 and 144-1 and the second plated layers 134-2 and 144-2 in advance to prevent diffusion of Te in thermoelectric material layers 132 and 142 to the first plated layers 134-1 and 144-1 and the second plated layers 134-2 and 144-2. Accordingly, generation of a Bi rich region may be prevented.

Accordingly, a Te content is greater than a Bi content from center portions of the thermoelectric material layers 132 and 142 to interfaces between the thermoelectric material layers 132 and 142 and the first bonding layers 136-1 and 146-1, and a Te content is greater than a Bi content from center portions of the thermoelectric material layers 132 and 142 to interfaces between the thermoelectric material layers 132 and 142 and the second bonding layers 136-2 and 146-2. The Te content from the center portions of the thermoelectric material layers 132 and 142 to interfaces between the thermoelectric material layers 132 and 142 and the first bonding layers 136-1 and 146-1 or the Te content from the center portions of the thermoelectric material layers 132 and 142 to interfaces between the thermoelectric material layers 132 and 142 and the second bonding layers 136-2 and 146-2 may be 0.8 to 1 times a Te content in the center portions of the thermoelectric material layers 132 and 142. For example, a Te content in a thickness within 100 $\mu$m in a direction from the interfaces between the thermoelectric material layers 132 and 142 and the first bonding layers 136-1 and 146-1 to the center portions of the thermoelectric material layers 132 and 142 may be 0.8 to 1 times the Te content in the center portions of the thermoelectric material layers 132 and 142. Here, the Te content in the thickness within 100 $\mu$m in the direction from the interfaces between the thermoelectric material layers 132 and 142 and the first bonding layers 136-1 and 146-1 to the center portions of the thermoelectric material layers 132 and 142 may be uniformly maintained, for example, a change rate of a Te weight ratio in the thickness within 100 $\mu$m in the direction from the interfaces between the thermoelectric material layers 132 and 142 and the first bonding layers 136-1 and 146-1 to the center portions of the thermoelectric material layers 132 and 142 may be 0.9 to 1.

Further, a Te content in the first bonding layers 136-1 and 146-1 or the second bonding layers 136-2 and 146-2 may be the same as or similar to the Te content in the thermoelectric material layers 132 and 142. For example, the Te content in the first bonding layers 136-1 and 146-1 or the second bonding layers 136-2 and 146-2 may be 0.8 to 1 times the Te content in the thermoelectric material layers 132 and 142, preferably, 0.85 to 1 times, more preferably, 0.9 to 1 times, and even more preferably, 0.95 to 1 times. Here, the content may be a weight ratio. For example, when the Te content in the thermoelectric material layers 132 and 142 is included at 50 wt%, the Te content in the first bonding layers 136-1 and 146-1 or the second bonding layers 136-2 and 146-2 may be 40 to 50 wt%, preferably, 42.5 to 50 wt%, more preferably, 45 to 50 wt%, and even more preferably, 47.5 to 50 wt%. Further, the Te content in the first bonding layers 136-1 and 146-1 or the second bonding layers 136-2 and 146-2 may be greater than a Ni content. The Te content in the first bonding layers 136-1 and 146-1 or the second bonding layers 136-2 and 146-2 is uniformly distributed, however, the Ni content may be reduced in the first bonding layers 136-1 and 146-1 or the second bonding layers 136-2 and 146-2 in a direction closer to the thermoelectric material layers 132 and 142.

Further, a Te content from the interfaces between the thermoelectric material layers 132 and 142 and the first bonding layers 136-1 and 146-1 or the interfaces between the thermoelectric material layers 132 and 142 and the second bonding layers 136-2 and 146-2 to interfaces between the first plated layers 136-1 and 146-1 and the first bonding layers 136-1 and 146-1 or interfaces between the second plated layers 134-2 and 144-2 and the second bonding layers 136-2 and 146-2 may be uniformly distributed. For example, a change rate of a Te weight ratio from the interfaces between the thermoelectric material layers 132 and 142 and the first bonding layers 136-1 and 146-1 or the interfaces between the thermoelectric material layers 132 and 142 and the second bonding layers 136-2 and 146-2 to the interfaces between the first plated layers 136-1 and 146-1 and the first bonding layers 136-1 and 146-1 or the interfaces between the second plated layers 134-2 and 144-2 and the second bonding layers 136-2 and 146-2 may be 0.8 to 1. Here, it may mean that the Te content from the interfaces between the thermoelectric material layers 132 and 142 and the first bonding layers 136-1 and 146-1 or the interfaces between the thermoelectric material layers 132 and 142 and the second bonding layers 136-2 and 146-2 to the interfaces between the first plated layers 136-1 and 146-1 and the first bonding layers 136-1 and 146-1 or the interfaces between the second plated layers 134-2 and 144-2 and the second bonding layers 136-2 and 146-2 may be uniformly distributed when the change rate of the Te weight ratio is close to 1.

Further, a Te content in surfaces of the first bonding layers 136-1 and 146-1 which come into contact with the first plated layers 134-1 and 144-1, that is, interfaces between the first plated layers 136-1 and 146-1 and the first bonding layers 136-1 and 146-1, or in surfaces of the second bonding layers 136-2 and 146-2 which come into contact with the second plated layers 134-2 and 144-2, that is, interfaces between the second plated layers 134-2 and 144-2 and the second bonding layers 136-2 and 146-2 may be 0.8 to 1 times, preferably, 0.85 to 1 times, more preferably, 0.9 to 1 times, and even more preferably, 0.95 to 1 times the Te content in surfaces of the thermoelectric material layers 132 and 142 which come into contact with the first bonding layers 136-1 and 146-1, that is, interfaces between the thermoelectric material layers 132 and 142 and the first bonding layers 136-1 and 146-1, in surfaces of the thermoelectric material layers 132 and 142 which come into contact with the second bonding layers 136-2 and 146-2, that is, interfaces between the thermoelectric material layers 132 and 142 and the second bonding layers 136-2 and 146-2. Here, the content may be a weight ratio.

Further, the Te content of the center portions of the thermoelectric material layers 132 and 142 may be the same as or similar to the Te content of the interfaces between the thermoelectric material layers 132 and 142 and the first bonding layers 136-1 and 146-1 or the interfaces between the thermoelectric material layers 132 and 142 and the second bonding layers 136-2 and 146-2. That is, the Te content of the interfaces between the thermoelectric material layers 132 and 142 and the first bonding layers 136-1 and 146-1 or the interfaces between the thermoelectric material layers 132 and 142 and the second bonding layers 136-2 and 146-2 may be 0.8 to 1 times, preferably, 0.85 to 1 times, more preferably, 0.9 to 1 times, and even more preferably, 0.95 to 1 times the Te content of the center portions of the thermoelectric material layers 132 and 142. Here, the content may be a weight ratio. Here, the center portions of the thermoelectric material layers 132 and 142 may refer to surrounding regions including centers of the thermoelectric material layers 132 and 142. Further, the interfaces may refer to the interfaces themselves or may include the interfaces and regions around the interfaces which are adjacent to the interfaces within a predetermined distance.

Further, the Te content in the first plated layers 136-1 and 146-1 or the second plated layers 134-2 and 144-2 may be shown to be lower than the Te content in the thermoelectric material layers 132 and 142 or the Te content in the first bonding layers 136-1 and 146-1 or the second bonding layers 136-2 and 146-2.

In addition, the Bi content of the center portions of the thermoelectric material layers 132 and 142 may be the same as or similar to a Bi content of the interfaces between the thermoelectric material layers 132 and 142 and the first bonding layers 136-1 and 146-1 or the interfaces between the thermoelectric material layers 132 and 142 and the second bonding layers 136-2 and 146-2. Accordingly, since the Te content is shown to be greater than the Bi content from the center portions of the thermoelectric material layers 132 and 142 to the interfaces between the thermoelectric material layers 132 and 142 and the first bonding layers 136-1 and 146-1 or the interfaces between the thermoelectric material layers 132 and 142 and the second bonding layers 136-2 and 146-2, an interval in which the Bi content is greater than the Te content is not present around the interfaces between the thermoelectric material layers 132 and 142 and the first bonding layers 136-1 and 146-1 or the interfaces between the thermoelectric material layers 132 and 142 and the second bonding layers 136-2 and 146-2. For example, the Bi content of the center portions of the thermoelectric material layers 132 and 142 may be 0.8 to 1 times, preferably, 0.85 to 1 times, more preferably, 0.9 to 1 times, and even more preferably, 0.95 to 1 times the Bi content of the interfaces between the thermoelectric material layers 132 and 142 and the first bonding layers 136-1 and 146-1 or the interfaces between the thermoelectric material layers 132 and 142 and the second bonding layers 136-2 and 146-2. Here, the content may be a weight ratio.

Here, the lower electrodes 120 disposed between the lower substrate 110 and the P-type thermoelectric leg 130 and the N-type thermoelectric leg 140, and the upper electrodes 150 disposed between the upper substrate 160 and the P-type thermoelectric leg 130 and the N-type thermoelectric leg 140 may each include at least one among copper (Cu), silver (Ag), and nickel (Ni).

Further, the lower substrate 110 and the upper substrate 160 facing each other may be insulating substrates or metal substrates. The insulating substrate may be an alumina substrate or a polymer resin substrate having flexibility. The polymer resin substrate having flexibility may include various insulating resin materials such as polyimide (PI), polystyrene (PS), polymethyl methacrylate (PMMA), cyclic olefin copoly (COC), polyethylene terephthalate (PET), high transmission plastic such as a resin, and the like. Alternatively, the insulating substrate may also be a fabric. The metal substrate may include Cu, a Cu alloy, or a Cu-Al alloy. Further, when each of the lower substrate 110 and the upper substrate 160 are the metal substrate, a dielectric layer 170 may be further formed at each of a space between the lower substrate 110 and the lower electrodes 120 and a space between the upper substrate 160 and the upper electrodes 150. The dielectric layer 170 may include a material having a heat conductivity of 5 to 10 W/K.

In this case, sizes of the lower substrate 110 and the upper substrate 160 may be formed to be different. For example, a volume, a thickness, or an area of one of the lower substrate 110 and the upper substrate 160 may be formed to be greater than a volume, a thickness, or an area of the other one. Accordingly, heat absorption performance or heat dissipation performance of the thermoelectric device may be improved.

Further, a heat dissipation pattern, for example, an uneven pattern, may be formed in a surface of at least one of the lower substrate 110 and the upper substrate 160. Accordingly, the heat dissipation performance of the thermoelectric device may be improved. When the uneven pattern is formed in a surface which comes into contact with the P-type thermoelectric legs 130 or the N-type thermoelectric legs 140, a bonding characteristic between the thermoelectric legs and the substrates may be improved.

Meanwhile, the P-type thermoelectric leg 130 or the N-type thermoelectric leg 140 may have a cylindrical shape, a polygonal pillar shape, an elliptical pillar shape, and the like.

Further, the P-type thermoelectric leg 130 or the N-type thermoelectric leg 140 may have a stacked structure. For example, the P-type thermoelectric leg 130 or the N-type thermoelectric leg 140 may be formed using a method of stacking a plurality of structures on which a semiconductor material is coated on a sheet-shaped base material and then cutting the structures. Accordingly, material loss may be prevented and an electrical conduction characteristic may be improved.

Further, the P-type thermoelectric leg 130 or the N-type thermoelectric leg 140 may be manufactured in a zone melting manner or a powder sintering manner. According to the zone melting manner, the thermoelectric legs are obtained by a method of manufacturing an ingot using a thermoelectric material, slowly applying heat to the ingot to refine the ingot so that particles are rearranged in one direction, and then slowly cooling the ingot. According to the powder sintering manner, the thermoelectric legs are obtained through a process of manufacturing an ingot using a thermoelectric material, pulverizing and sieving the ingot to obtain powder for thermoelectric legs, and then sintering the powder.

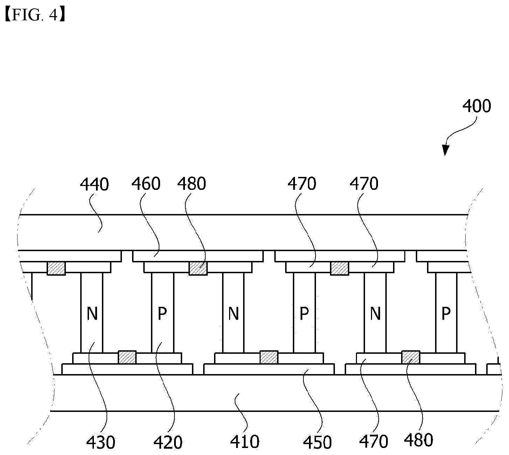

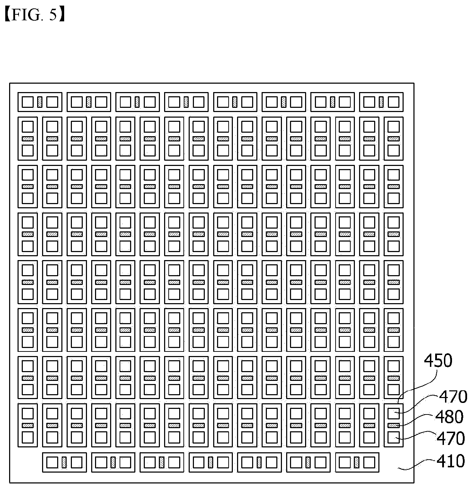

FIG. 4 is a cross-sectional view of a thermoelectric device according to one embodiment of the present invention, and FIG. 5 is a plan view of a substrate and an electrode structure of the thermoelectric device according to one embodiment of the present invention. Overlapping descriptions of contents which are the same as FIGS. 2 and 3 will be omitted.

Referring to FIGS. 4 to 6, a thermoelectric device 400 includes a first substrate 410, a plurality of P-type thermoelectric legs 420 and a plurality of N-type thermoelectric legs 430 alternately disposed on the first substrate 410, a second substrate 440 disposed on the plurality of P-type thermoelectric legs 420 and the plurality of N-type thermoelectric legs 430, a plurality of first electrodes 450 disposed between the first substrate 410 and the plurality of P-type thermoelectric legs 420 and the plurality of N-type thermoelectric legs 430, and a plurality of second electrodes 460 disposed between the second substrate 440 and the plurality of P-type thermoelectric legs 420 and the plurality of N-type thermoelectric legs 430.

In this case, the plurality of first electrodes 450 and the plurality of second electrodes 460 may each be disposed in an array shape of m*n (here, each of m and n may be an integer greater than or equal to 1, and m and n may be the same or different), but are not limited thereto. The plurality of first electrodes 450 and the plurality of second electrodes 460 may each be disposed in the array shape of m*n, and additional first electrodes 450 and second electrodes 460 may also be disposed at edges. Each first electrode 450 may be disposed to be spaced apart from other first electrodes 450 adjacent thereto. For example, each first electrode 450 may be disposed to be spaced apart from other first electrodes 450 adjacent thereto at a distance of 0.5 to 0.8 mm.

Further, a pair of P-type thermoelectric leg 420 and N-type thermoelectric leg 430 may be disposed on each first electrode 450, and a pair of P-type thermoelectric leg 420 and N-type thermoelectric leg 430 may be disposed on each second electrode 460.

In addition, one surface of the P-type thermoelectric leg 420 may be disposed on the first electrode 450, and the other surface of the P-type thermoelectric leg 420 is disposed on the second electrode 460, and one surface of the N-type thermoelectric leg 430 may be disposed on the first electrode 450, and the other surface of the N-type thermoelectric leg 430 may be disposed on the second electrode 460. When the P-type thermoelectric leg 420 of the pair of P-type thermoelectric leg 420 and N-type thermoelectric leg 430 disposed on the first electrode 450 is disposed on one of the plurality of second electrodes 460, the N-type thermoelectric leg 430 may be disposed on another second electrode 460 adjacent to the one second electrode 460. Accordingly, the plurality of P-type thermoelectric legs 420 and the plurality of N-type thermoelectric legs 430 may be serially connected through the plurality of first electrodes 450 and the plurality of second electrodes 460.

In this case, a pair of solder layers 470 which bonds the pair of P-type thermoelectric leg 420 and N-type thermoelectric leg 430 may be coated on the first electrode 450, and the pair of P-type thermoelectric leg 420 and N-type thermoelectric leg 430 may be disposed on the pair of solder layers 470. Here, the pair of solder layers 470 may be used with a pair of P-type solder layer and N-type solder layer, each P-type solder layer may be referred to as a solder layer which directly comes into contact with each P-type thermoelectric leg, and each N-type solder layer may be referred to as a solder layer which directly comes into contact with each N-type thermoelectric leg.

Meanwhile, the pair of P-type solder layer and N-type solder layer 470 may be spaced apart from each other, and a barrier layer 480 is disposed between the pair of P-type solder layer and N-type solder layer 470 on the first electrode 450. In this case, the barrier layer 480 has an insulation performance, may have a height greater than a height of each of the pair of P-type solder layer and N-type solder layer 470, and has a melting point greater than a melting point of each of the pair of P-type solder layer and N-type solder layer 470.

Accordingly, when the thermoelectric legs 420 and 430 are disposed on the solder layers 470 and exposed to a high temperature during a reflow process to assemble the thermoelectric device 400, since the barrier layer 480 is not melted even when the solder layers 470 are melted, a problem in which the solder layers 470 flow over the barrier layer 480 may be prevented. Further, even when the P-type solder layer or N-type solder layer 470 is partially melted and thus the P-type thermoelectric leg 420 or the N-type thermoelectric leg 430 is tilted, since the P-type thermoelectric leg 420 or the N-type thermoelectric leg 430 is blocked by the barrier layer 480, a short circuit between the P-type thermoelectric leg 420 and the N-type thermoelectric leg 430 may be prevented.

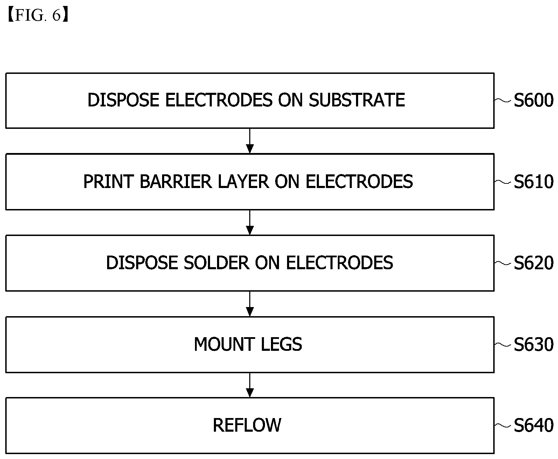

FIG. 6 is a flow chart illustrating a method of manufacturing the thermoelectric device according to one embodiment of the present invention.

Referring to FIG. 6, a plurality of first electrodes 450 are disposed on a first substrate 410 (S600). In this case, an adhesion layer may be disposed between the first substrate 410 and the plurality of first electrodes 450. To this end, the plurality of first electrodes 450 may be stacked on the first substrate 410 after coating an adhesive on the first substrate 410. Alternatively, after attaching the plurality of arranged first electrodes 450 to a flexible film, for example, a polyethylene (PE) film, the film may be removed after disposing the plurality of first electrodes 450 on the first substrate 410 on which the adhesive is coated in advance.

Further, a barrier layer 480 is printed on each of the electrodes 450 (S610). The barrier layer 480 may be printed on a middle region of each of the electrodes 450 and may be printed by a mask or directly printed.

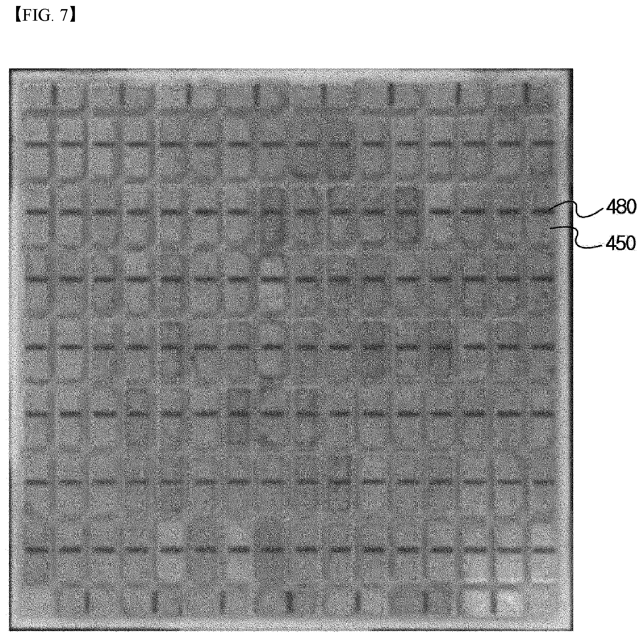

Further, solder layers 470 are disposed on the electrodes 450 (S620). The solder layers 470 may be disposed in pairs with the barrier layer 480 therebetween in each of the pairs. FIG. 7 is a photograph illustrating a region in which a plurality of electrodes are disposed on the substrate, and then a barrier layer is printed. As shown in FIG. 7, the barrier layer 480 may be printed in the middle region of each of the electrodes 450, and the pair of solder layers 470 may be disposed with the barrier layer 480 therebetween.

In this case, a melting point of the solder layer 470 may be lower than a melting point of the barrier layer 480. A process of operations S600 to S620 may be identically performed to manufacture the upper substrate and electrodes.

Further, thermoelectric legs 420 and 430 are disposed on the pair of solder layers 470 (S630), and the reflow process is performed (S640). Here, the pair of solder layers 470 may be used with a pair of P-type solder layer and N-type solder layer, and a P-type thermoelectric leg may be disposed on the P-type solder layer to come into contact with the P-type solder layer directly, and an N-type thermoelectric leg may be disposed on the N-type solder layer to come into contact with the N-type solder layer directly. The reflow process may be performed at a temperature greater than the melting point of the solder layer 470 and lower than the melting point of the barrier layer 480. Accordingly, the solder layers 470 may be partially melted and thus the thermoelectric legs 420 and 430 may be bonded with the solder layers 470, and the barrier layer 480 is not melted and thus it is possible to prevent a problem that the solder layers 470 flow over the barrier layer 480 or a problem of a short circuit occurring between the thermoelectric legs 420 and 430 with the barrier layer 480 therebetween.

Hereinafter, the embodiment of the present invention will be described in more detail.

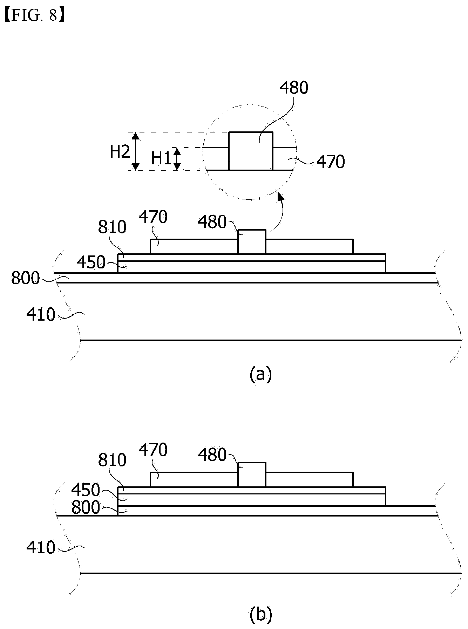

FIG. 8 is a cross-sectional view of a portion of the thermoelectric device according to one embodiment of the present invention.

Referring to FIG. 8, the electrode 450 is disposed on the substrate 410, the pair of solder layers 470 are disposed on the electrode 450, and the barrier layer 480 is disposed between the pair of solder layers 470 on the electrode 450.

In this case, the substrate 410 and the electrode 450 are adhered to each other by an adhesion layer 800. The adhesion layer 800 may include a resin composition having adhesive performance. An inorganic filler having heat conduction performance may be dispersed in the resin composition. For example, the inorganic filler may have a diameter in a range of 50 to 70 $\mu$m and may be formed of aluminum oxide. Accordingly, the adhesion layer 800 may have heat dissipation performance in addition to the adhesive performance.

In this case, as shown in FIG. 8A, the adhesion layer 800 may be coated on an entire surface of the substrate 410. Alternatively, as shown in FIG. 8B, the adhesion layer 800 may be coated to be partitioned according to the electrodes 450 disposed to be spaced apart from each other. As described above, when the adhesion layer 800 is coated to be partitioned according to the electrodes 450, a region on which the adhesion layer 800 is not disposed may be present in a portion of the substrate 410, and accordingly, since the adhesion layer 800 is not excessively coated on the substrate 410, the cooling capacity and heat dissipation characteristic of the thermoelectric device 400 may be maintained well. In addition, since a coating amount of the adhesion layer 800 may be sharply reduced, material costs may be reduced, and a short circuit due to movement of the remaining solder may be prevented.

In addition, a plated layer 810 may be further disposed on the electrode 450, and the pair of solder layers 470 and the barrier layer 480 may be disposed on the plated layer 810. The plated layer 810 may include nickel(Ni) or tin(Sn). When the plated layer 810 is disposed on the electrode layer 450 and then the solder layers 470 are disposed, since the metal layer 450 and the solder layers 470 may be bonded without thermal grease or adhesive, heat exchange efficiency between the electrode layer 450 and the solder layers 470 is improved, and it is possible to compact.

Meanwhile, according to the embodiment of the present invention, the pair of solder layers 470 may be disposed on the plated layer 810, and the barrier layer 480 may be further disposed between the pair of solder layers 470. The melting point of the barrier layer 480 is greater than the melting point of the solder layer 470, and a height H2 of the barrier layer 480 may be greater than a height H1 of the solder layer 470. Accordingly, when the reflow process is performed at a temperature between the melting point of the solder layer 470 and the melting point of the barrier layer 480, the solder layer 470 is partially melted to be bonded with the thermoelectric legs 420 and 430, and it becomes difficult for the melted solder layer 470 to flow over the barrier layer 480. Further, in this case, since the barrier layer 480 is not melted, and thus the thermoelectric legs 420 and 430 are supported by the barrier layer 480 even when the solder layers 470 are excessively melted and thus a lift between the thermoelectric legs 420 and 430 and the solder layers 470 is generated, probability of the short circuit between the thermoelectric legs 420 and 430 being generated may be reduced.

For example, the melting point of the plated layer 810 may be about 230 °C, the melting point of the solder layer 470 may be about 138 °C, and the melting point of the barrier layer 480 may be about 150°C. Further, the height H2 of the barrier layer 480 may be 1.1 to 10 times, preferably, 1.1 to 5 times, and more preferably, 1.1 to 3 times the height H1 of the solder layer 470. For example, the height H2 of the barrier layer 480 may be about 1 to 100 $\mu$m, preferably, 5 to 50 $\mu$m, and more preferably, 10 to 30 $\mu$m. When a relationship between the height H2 of the barrier layer 480 and the height H1 of the solder layer 470 deviates from such ranges, the solder layers 470 melted through the flow process may flow over the barrier layer 480, or a process of disposing the solder layers 470 after disposing the barrier layer 480 may become difficult.

In this case, side surfaces 480 of the barrier layer 480 may come into contact with the solder layers 470. For example, the pair of solder layers 470 may be disposed adjacent to the barrier layer 480, and side surfaces of the pair of solder layers 470 may be formed to come into contact with the side surface of the barrier layer 480 after the reflow process.

According to the embodiment of the present invention, the barrier layer 480 may be formed of an adhesive which includes an epoxy resin, has an insulation performance, and is attachable to metal. For example, the barrier layer 480 may have a peeling strength of 20 N/mm$^2$ or more at 25 °C, 15 N/mm$^2$ or more at 90 °C, 12 N/mm$^2$ or more at 125 °C, and 4 N/mm$^2$ or more at 150 °C with metal such as copper, aluminum, nickel, tin, and the like. As described above, when the barrier layer 480 has an insulation performance, the performance of the thermoelectric device 400 may not be influenced even when the barrier layer 480 comes into contact with the solder layers 470 or comes into contact with the thermoelectric legs 420 and 430. Further, when the barrier layer 480 is formed of an adhesive attachable to the metal, the barrier layer 480 is directly adhered to the electrodes 450 or the plated layer 810 and thus may not be easily separated from the thermoelectric device 400.

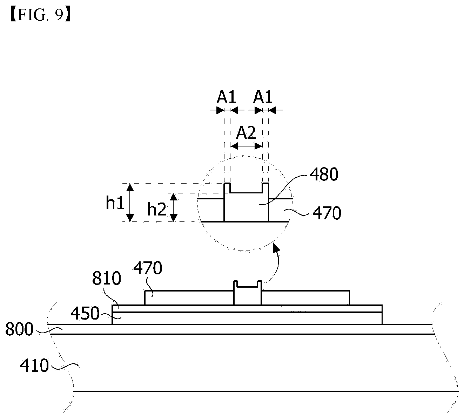

FIGS. 9 to 11 are cross-sectional views of a portion of a thermoelectric device according to another embodiment of the present invention. Overlapping descriptions of contents the same as the contents described in FIG. 8 will be omitted.

Referring to FIGS. 9 to 11, the barrier layer 480 includes first regions A1 each having a first height h1 and a second region A2 having a second height h2 lower than the first height h1, wherein at least portions of the first regions A1 come into contact with the side surfaces of the pair of solder layers 470, and the second region A2 is surrounded by the first regions A1. When the barrier layer 480 is printed in the above-described shape, printing defects may be prevented, and a problem that the melted solder layers 470 flow over the barrier layer 480 may be prevented.

For example, the first height h1 may be 1.01 to 1.2 times the second height h2, and the first region A1 may have an area of 0.01 to 10% of an entire area of the barrier layer 480. When the first height h1 is smaller than 1.01 times the second height h2, it is difficult for the first height h1 to serve as a barrier which prevents the solder layers 470 from flowing due to the first region A1, and when the first height h1 is greater than 1.01 to 1.2 times the second height h2, the first region A1 becomes fragile and thus may be easily broken. Further, when an area of the first region A1 is greater than 10% of the entire area of the barrier layer 480, since overall strength of the barrier layer 480 becomes weak, there is a problem that it is difficult to sufficiently serve as a barrier between the thermoelectric legs 420 and 430.

Meanwhile, referring to FIGS. 10 to 12, not all of the side surfaces of the solder layers 470 may come into contact with the side surfaces of the barrier layer 480, but only some of the side surfaces of the solder layers 470 may come into contact with the side surfaces of the barrier layer 480. The above described shape may be formed in a process in which the solder layers 470 are partially melted and thus flow to the barrier layer 480 during the reflow process in the case in which the solder layers 470 and the barrier layer 480 are disposed to be spaced apart from each other when the barrier layer 480 is printed and then the solder layers 470 are disposed. As described above, in the case in which the solder layers 470 and the barrier layer 480 are disposed to be spaced apart when the solder layers 470 are disposed, since the solder layers 470 are not coated with an excessive amount of solder, a problem of the solder layers 470 flowing may be prevented.

In the description, although the first substrate 410 and the first electrodes 450 are mainly described for convenience of description, the same structure may be applied to the second substrate 440 and the second electrodes 460. Alternatively, the structure according to the present disclosure may be applied to only the first substrate 410 and the first electrodes 450, and a barrier layer may not be disposed on the second substrate 440 and the second electrode 460, and alternatively, the structure according to the present disclosure may be applied to only the second substrate 440 and the second electrodes 460, and a barrier layer may not be disposed on the first substrate 410 and the first electrodes 450.

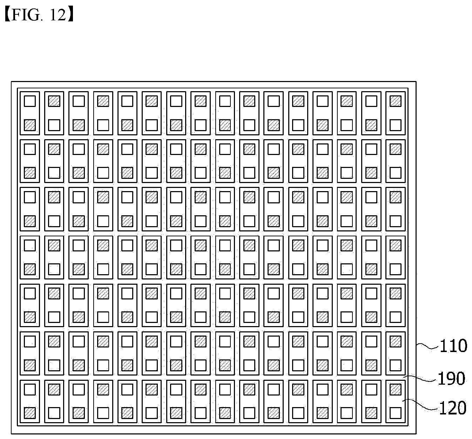

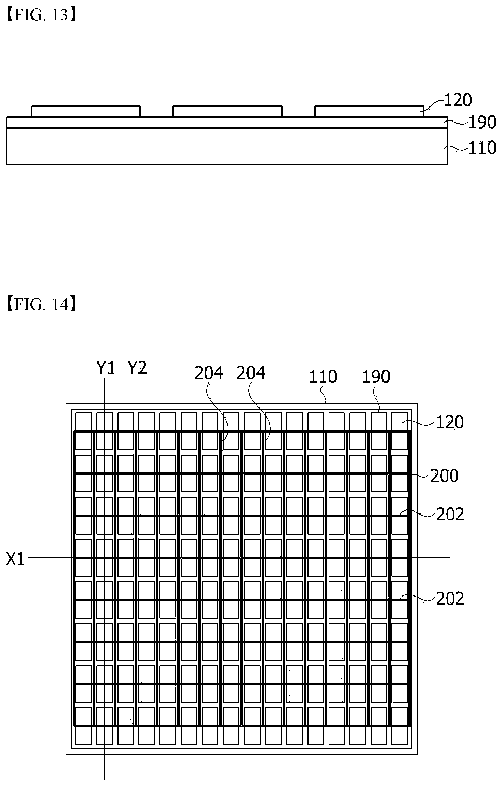

Meanwhile, FIG. 12 is a view illustrating an example of a substrate and an electrode structure included in the thermoelectric device, and FIG. 13 is a cross-sectional view of FIG. 12.

A space between the lower substrate 110 and the lower electrodes 120 and a space between the upper substrate 160 and the upper electrodes 150 may be directly bonded or adhered by an adhesion layer. When the space between the lower substrate 110 and the lower electrodes 120 and the space between the upper substrate 160 and the upper electrodes 150 are directly bonded, heat conductivity is advantageous in comparison with the case of adhesion by the adhesion layer, but reliability is inferior due to a large thermal expansion coefficient difference between the substrate and the electrode.

Referring to FIGS. 12 and 13, an adhesion layer 190 may be coated on the lower substrate 110, and a plurality of lower electrodes 120 may be disposed on the adhesion layer 190 in an array shape. Further, a pair of thermoelectric legs (not shown) may be bonded to each of the lower electrodes 120. Structures of the lower substrate 110 and the lower electrodes 120 are mainly described for convenience of descriptions, but are not limited thereto, and the same structure may be applied to the upper substrate 160 and the upper electrodes 150. In this case, the lower substrate 110 is a ceramic substrate and may have a heat conductivity of about 20 W/mK, and the lower electrodes 120 may have a heat conductivity of about 100 W/mK. When power is applied to the thermoelectric device 100, although one of the upper substrate 160 and the lower substrate 110 becomes a heating surface and thus has a high probability of expansion and the other one becomes a heat absorption surface and thus has a high probability of contraction, the adhesion layer 190 may serve as a buffer which absorbs a thermal shock between the lower substrate 110 and the lower electrodes 120 or the upper substrate 160 and the upper electrodes 150.

However, since the adhesion layer 190 is weak to heat, the adhesion layer 190 is degraded during a reflow process treated at a temperature of about 300 °C or more, and thus the lower electrodes 120 may be easily separated from the lower substrate 110.

According to the embodiment of the present invention, the substrate and the electrodes will be fixed to each other using an electrode fixing member. However, the lower substrate and the lower electrodes are described as an example for convenience of description, and the same structure may be applied to the upper substrate and the upper electrodes.

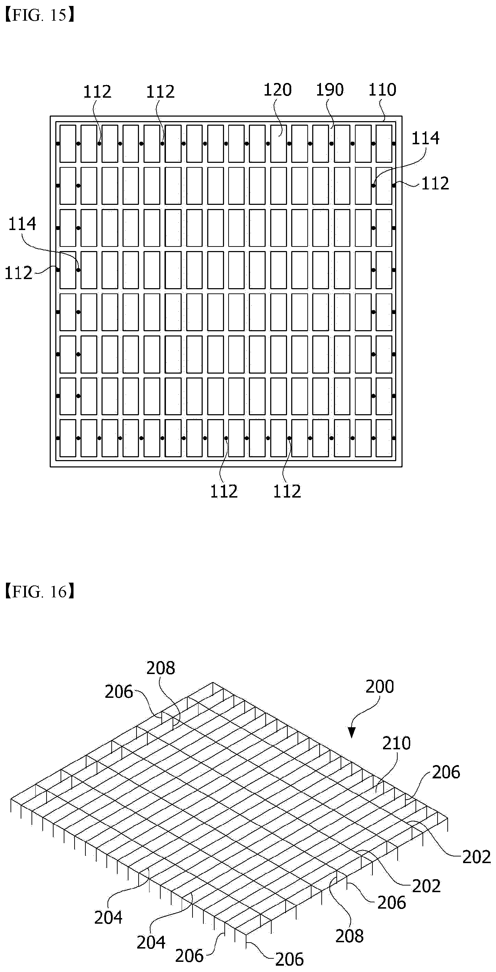

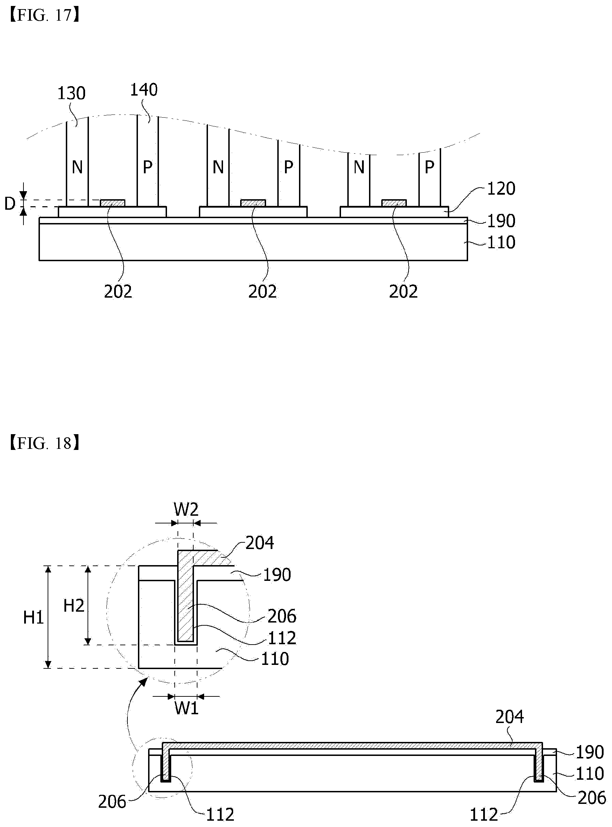

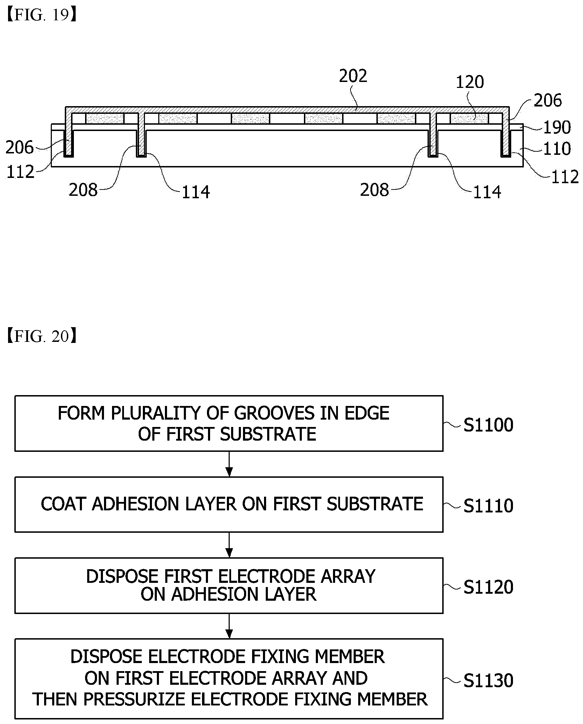

FIG. 14 is a top view in which an electrode fixing member is disposed on a lower substrate and lower electrodes of the thermoelectric device according to one embodiment of the present invention, FIG. 15 is a top view of the lower substrate and the lower electrodes of the thermoelectric device according to one embodiment of the present invention, and FIG. 16 is a perspective view of an electrode fixing member according to one embodiment of the present invention. FIG. 17 is a cross-sectional view taken along line Y1 in FIG. 14, FIG. 18 is a cross-sectional view taken along line Y2 in FIG. 14, and FIG. 19 is a cross-sectional view taken along line X1 in FIG. 14.

Referring to FIGS. 14 to 19, the lower electrodes 120 (hereinafter, may also be used as a plurality of first electrodes) are disposed on the lower substrate 110 (hereinafter, may also be used as a first substrate). In this case, the plurality of first electrodes 120 may have an array shape of m*n (here, each of m and n may be an integer greater than or equal to 1), and one column may be spaced apart from another column adjacent thereto at a predetermined interval, and like the above, one row may be spaced apart from another row adjacent thereto at a predetermined interval. An adhesion layer 190 may be disposed between the first substrate 110 and the plurality of first electrodes 120. A pair of N-type thermoelectric leg 130 and P-type thermoelectric leg 140 are disposed on the first electrodes 120. In addition, overlapping descriptions of contents the same as the contents described in FIGS. 1 to 13 will be omitted. Although not shown, the first electrodes 120 may be bonded to the pair of N-type thermoelectric leg 130 and P-type thermoelectric leg 140 by the solder layers.

According to the embodiment of the present invention, a plurality of first grooves 112 are formed in an edge of the first substrate 110. In this case, the plurality of first grooves 112 are formed in the edge of the first substrate 110 and may be formed in points, in which the plurality of first electrodes 120 are not disposed, in advance. For example, the plurality of first grooves 112 may be formed in side surfaces of the first electrodes 120 forming the outermost column and the outermost row among the plurality of first electrodes 120. More specifically, the plurality of first grooves 112 may be formed in middle points of one side surfaces in a longitudinal direction of the first electrodes 120 forming the outermost column and the outermost row among the plurality of first electrodes 120. Here, the longitudinal direction may refer to a direction having a great length when a shape of the first electrode 120 is a rectangular shape, and the N-type thermoelectric legs 130 and the P-type thermoelectric legs 140 may be disposed in the longitudinal direction. That is, the middle point of one side surface in the longitudinal direction of the first electrode 120 may be a point corresponding to a side surface between the N-type thermoelectric leg 130 and the **P-**type thermoelectric leg 140.

The thermoelectric device 100 according to the embodiment of the present invention further includes an electrode fixing member 200 which fixes the first substrate 110 and the plurality of first electrodes 120. To this end, a portion of the electrode fixing member 200 may be fit into at least some of the plurality of first grooves 112 formed in the first substrate 110, and the remaining portion of the electrode fixing member 200 may be disposed on the plurality of first electrodes 120.

Specifically, the electrode fixing member 200 may include a plurality of first lines 202 in a first direction, a plurality of second lines 204 in a second direction crossing the first direction, and third lines 206 which extend from both ends of the plurality of first lines 202 and both ends of the plurality of second lines 204 in directions perpendicular to the plurality of first lines 202 and the plurality of second lines 204 to be inserted into the plurality of first grooves 112. In this case, the plurality of first lines 202 and the plurality of second lines 204 cross each other to form a plurality of openings 210. For example, the plurality of first lines 202 and the plurality of second lines 204 may form a mesh shape.

Accordingly, at least some of the plurality of first lines 202 are disposed on each of the plurality of first electrodes 120 and may be disposed between the pair of N-type thermoelectric leg 130 and P-type thermoelectric leg 140. In this case, at least some of the plurality of first lines 202 may be disposed between the pair of N-type thermoelectric leg 130 and P-type thermoelectric leg 140 to be in close contact with the plurality of first electrodes 120. That is, with respect to the openings 210, in each of the openings 210, the N-type thermoelectric leg 130 disposed on one first electrode 120 and the P-type thermoelectric leg 140 disposed on another first electrode 120 adjacent to the one first electrode 120 may be disposed, and the two first lines 202 forming the openings 210 may be disposed between the pair of N-type thermoelectric leg 130 and P-type thermoelectric leg 140 to be in close contact with the plurality of first electrodes 120, and the two second lines 204 may be disposed between the plurality of first electrodes 120.

As described above, when the electrode fixing member 200 is disposed to be in close contact with the plurality of first electrodes 120 and is fit into the plurality of first grooves 112 formed in the first substrate 110, the first substrate 110 and the plurality of first electrodes 120 may be firmly fixed, and a problem that at least some of the plurality of first electrodes 120 are separated from the first substrate 110 may be prevented.

In this case, the electrode fixing member 200 may be formed of an insulating material. For example, the electrode fixing member 200 may be formed of a ceramic material, and more specifically, alumina. Accordingly, even when the electrode fixing member 200 is disposed to be in close contact with the plurality of first electrodes 120, the electrode fixing member 200 may not electrically influence the thermoelectric device 100.

Meanwhile, according to the embodiment of the present invention, the adhesion layer 190 may be further disposed between the first substrate 110 and the plurality of first electrodes 120, and at least some of the plurality of second lines 204 may be disposed on the adhesion layer 190 between the plurality of first electrodes 120. Accordingly, the mesh-shaped electrode fixing member 200 may have stable supporting strength and may not disturb the arrangement of the N-type thermoelectric legs 130 and the P-type thermoelectric legs 140.

Here, the adhesion layer 190 may include a resin composition having adhesive performance. An inorganic filler having heat conduction performance may be dispersed in the resin composition. For example, the inorganic filler may include aluminum oxide. Accordingly, the adhesion layer 190 may have heat dissipation performance in addition to the adhesive performance. Further, an example in which the adhesion layer 190 is coated on an entire surface of the first substrate 110 is described, but the present invention is not limited thereto. The adhesion layer 190 may be disposed to be partitioned according to the plurality of first electrodes 120. That is, the adhesion layer 190 is not disposed on the entire surface of the first substrate 110 but may be disposed on each of the first electrodes 120 which are disposed to be spaced apart from each other. Accordingly, a region on which the adhesion layer 190 is not disposed may present in at least a portion of the first substrate 110. Since the adhesion layer 190 is not excessively coated on the first substrate 110 while serving as a buffer which absorbs a thermal shock to the first substrate 110, the cooling capacity and heat dissipation characteristic of the thermoelectric device 100 may be well maintained. In addition, since a coating amount of the adhesion layer 190 may be sharply reduced, material costs may be reduced, and a short circuit due to movement of the remaining solder may be prevented.

Meanwhile, referring to FIG. 17, a thickness D of each of the plurality of first lines 202 and the plurality of second lines 204 may be 0.1 mm to 1 mm, preferably, 0.2 mm to 0.9 mm, and more preferably, 0.3 mm to 0.8 mm. Accordingly, the electrode fixing member 200 may have stable supporting strength, and even when solder which bonds the first electrodes 120 to the N-type thermoelectric leg 130 or the P-type thermoelectric leg 140 is melted through the reflow process, a situation in which the melted solder flows to the thermoelectric leg or electrode adjacent thereto may be blocked by the plurality of first lines 202 and the plurality of second lines 204.

Although not shown, a thickness of each of the plurality of first lines 202 and a thickness of each of the plurality of second lines 204 may be different. For example, the plurality of first lines 202 may are disposed on the plurality of first electrodes 120, and the plurality of second lines 204 may be disposed between the plurality of first electrodes 120. Accordingly, the thickness of each of the plurality of second lines 204 may be greater than the thickness of each of the plurality of first lines 202 by a thickness of the electrode.

Further, referring to FIG. 18, a depth H2 of each of the plurality of first grooves 112 formed in the first substrate 110 may be 0.1 to 0.9 times, preferably, 0.3 to 0.9 times, and more preferably, 0.5 to 0.9 times a height H1 of the first substrate 110. Accordingly, the electrode fixing member 200 may be stably coupled to the plurality of first grooves 112 formed in the first substrate 110, and a problem that the third lines 206 of the electrode fixing member 200 protrude to a lower surface of the first substrate 110 may be prevented.

In this case, a width W1 of each of the plurality of first grooves 112 may be greater than a width W2 of each of the third lines 206, and a tolerance between wall surfaces of the plurality of first grooves 110 and the third lines 206 may be filled with adhesives. Accordingly, the electrode fixing member 200 may be easily mounted in the plurality of first grooves 112.

Further, referring to FIG. 19, a plurality of second grooves 114 are further formed in at least some of points spaced apart from the plurality of first grooves 112 at a predetermined interval in the first substrate 110, and the electrode fixing member 200 may further include fourth lines 208 which extend from points spaced apart from both ends of the plurality of first lines 202 at a predetermined interval in the directions perpendicular to the plurality of first lines 202 and the plurality of second lines 204 to be inserted into the plurality of second grooves 114. Accordingly, the electrode fixing member 200 may be more stably coupled to the first substrate 110. The plurality of second grooves 114 may be formed around, for example, a column adjacent to the outermost column or a row adjacent to the outermost row among the plurality of first electrodes 120. That is, the predetermined interval may be a longitudinal interval of each of the plurality of first electrodes 120. Here, the longitudinal direction may refer to a direction having a small length when a shape of the first electrode 120 is a rectangular shape.

FIG. 20 is a flow chart illustrating a method of disposing the substrate and the electrode of the thermoelectric device according to the embodiment of the present invention.

Referring to FIG. 20, the plurality of grooves 112 and 114 are formed in the edge of the first substrate 110 (S1100). Here, a depth of each of the grooves 112 and 114 may be 0.1 to 0.9 times a height of the first substrate 110.

Further, the adhesion layer 190 is coated on the first substrate 110 (S1110). Here, the adhesion layer 190 may include a resin composition having adhesive performance, and adhesives may flow into the grooves 112 and 114 of the first substrate 110.

Further, the plurality of first electrodes 120 are disposed on the adhesion layer 190 in an array shape (S1120). In this case, the plurality of first electrodes 120 may have an array shape of m*n (here, each of m and n may be an integer greater than or equal to 1), and one column may be spaced apart from another column adjacent thereto at a predetermined interval, and like the above, one row may be spaced apart from another row adjacent thereto at a predetermined interval.

In addition, the electrode fixing member 200 is disposed on the array-shaped plurality of first electrodes 120 and then pressurized (S1130). In this case, the third lines 206 and the fourth lines 208 of the electrode fixing member 200 may be inserted into the grooves 112 and 114 of the first substrate 110, and the first lines 202 may be disposed at middle points in the longitudinal direction of the first electrode 120, that is, between a region in which the N-type thermoelectric legs 130 are disposed and a region in which the P-type thermoelectric leg 140 are disposed. Accordingly, the electrode fixing member 200 may firmly fix the first substrate 110 and the plurality of first electrodes 120.

Here, in the description, the embodiment in which the barrier layer is disposed on the electrodes according to FIGS. 4 to 11 and the embodiment in which the electrode fixing member is disposed on the electrode according to FIGS. 12 to 20 are separately described, but the embodiments may be combined with each other.

For example, a portion of the electrode fixing member disposed on the electrode according to FIGS. 12 to 20 may be the barrier layer disposed on the electrodes according to FIGS. 4 to 11. Alternatively, the electrode fixing member according to FIGS. 12 to 20 may be further disposed on the electrodes on which the barrier layer is disposed according to FIGS. 4 to 11.

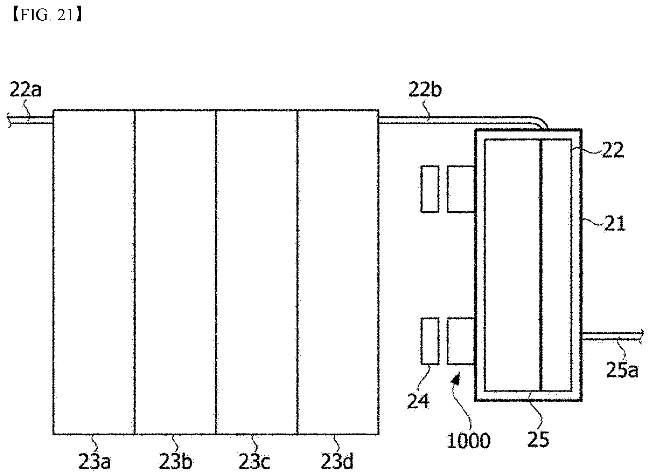

Hereinafter, an example in which the thermoelectric device according to the embodiment of the present invention is applied to a water purifier will be described with reference to FIG. 21.

FIG. 21 is a block diagram of a water purifier to which the thermoelectric device according to the embodiment of the present invention is applied.

A water purifier 1 to which the thermoelectric device according to the embodiment of the present invention is applied includes a raw water supply pipe 12a, a purified water tank introduction pipe 12b, a purified water tank 12, a filter assembly 13, a cooling fan 14, a heat storage tank 15, a cold water supply pipe 15a, and a thermoelectric apparatus 1000.

The raw water supply pipe 12a is a supply pipe which introduces water to be purified into the filter assembly 13 from a water source, the purified water tank introduction pipe 12b is an introduction pipe which introduces the water purified from the filter assembly 13 into the purified water tank 12, and the cold water supply pipe 15a is a supply pipe from which cold water cooled in the purified water tank 12 by thermoelectric apparatus 1000 by a predetermined temperature is supplied to a user.

The purified water tank 12 temporarily accommodates the purified water so that the water purified through the filter assembly 13 and introduced through the purified water tank introduction pipe 12b is stored and supplied to the outside.

The filter assembly 13 is composed of a sediment filter 13a, a pre carbon filter 13b, a membrane filter 13c, and a post carbon filter 13d.

That is, water introduced into the raw water supply pipe 12a may be purified through the filter assembly 13.

The heat storage tank 15 is disposed between the purified water tank 12 and the thermoelectric apparatus 1000, cold air formed from the thermoelectric apparatus 1000 is stored in the heat storage tank 15. The cold air stored in the heat storage tank 15 is transferred to the purified water tank 12 and cools the water accommodated in the purified water tank 12.

For smooth cold air transference, the heat storage tank 15 may come into surface contact with the purified water tank 12.

As described above, the thermoelectric apparatus 1000 is provided with a heat absorption surface and a heating surface, wherein one side is cooled and the other side is heated due to electron movement on a P-type semiconductor and an N-type semiconductor.

Here, the one side may be a side at the purified water tank 12, and the other side may be a side opposite the purified water tank 12.

Further, as described above, since the thermoelectric apparatus 1000 exhibits excellent waterproof and dustproof performance and has the improved heat flow performance, the thermoelectric apparatus 1000 may efficiently cool the purified water tank 12 in the water purifier.

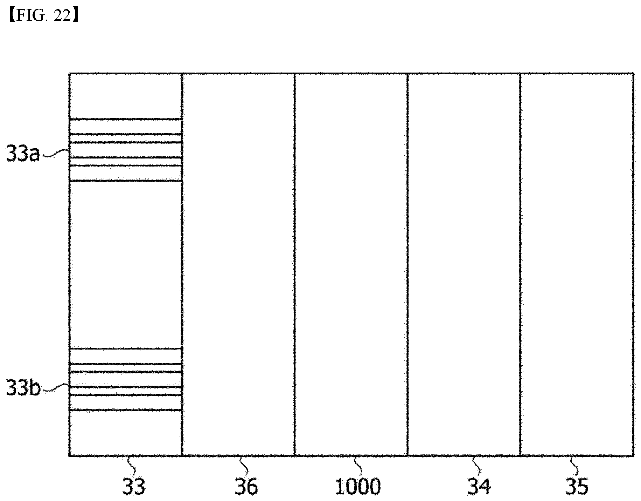

Hereinafter, an example in which the thermoelectric device according to the embodiment of the present invention is applied to a refrigerator will be described with reference to FIG. 22.

FIG. 22 is a block diagram of a refrigerator to which the thermoelectric device according to the embodiment of the present invention is applied.

The refrigerator includes a deep evaporation chamber cover 23, an evaporation chamber partition wall 24, a main evaporator 25, a cooling fan 26, and a thermoelectric apparatus 1000 in a deep evaporation chamber.

The inside of the refrigerator is portioned into a deep storage chamber and the deep evaporation chamber by the deep evaporation chamber cover 23.

Specifically, an inner space which is a front of the deep evaporation chamber cover 23 may be defined as the deep storage chamber, and an inner space which is a rear of the deep evaporation chamber cover 23 may be defined as the deep evaporation chamber.

A discharge grill 23a and a suction grill 23b may be formed in a front surface of the deep evaporation chamber cover 23.

The evaporation chamber partition wall 24 is installed at a point spaced apart from a back wall of an inner cabinet in a frontward direction to partition a space in which a deep storage chamber system is placed and a space in which the main evaporator 25 is placed.

Cold air cooled by the main evaporator 25 is supplied to a freezer compartment and then returns to the main evaporator.

The thermoelectric apparatus 1000 is accommodated in the deep evaporation chamber and forms a structure of which a heat absorption surface faces a drawer assembly of the deep storage chamber and a heating surface faces the evaporator. Accordingly, a heat absorption phenomenon which occurs in the thermoelectric apparatus 1000 may be used to quickly cool food stored in the drawer assembly in an ultra-low temperature below a temperature of 50 °C.

Further, as described above, since the thermoelectric apparatus 1000 exhibits excellent waterproof and dustproof performance and has the improved heat flow performance, the drawer assembly may be efficiently cooled in the refrigerator.

The thermoelectric device according to the embodiment of the present invention may be applied to a power generation device, a cooling device, a heating device, and the like. Specifically, the thermoelectric device according to the embodiment of the present invention may be mainly applied to an optical communication module, a sensor, a medical device, a measuring device, the aerospace industry, a refrigerator, a chiller, an automotive ventilation seat, a cup holder, a washing machine, a dryer, a wine cellar, a water purifier, a power supply device for a sensor, a thermopile, and the like. Alternatively, the thermoelectric device according to the embodiment of the present invention may be applied to a power generation device that generates electricity using waste heat generated from an engine of an automobile, a ship, or the like.

Here, a polymerase chain reaction (PCR) device is an example in which the thermoelectric device according to the embodiment of the present invention is applied to a medical device. The PCR device is equipment which determines a deoxyribonucleic acid (DNA) base sequence by amplifying DNA and is a device which demands precise temperature control and requires a thermal cycle. To this end, a Peltier-based thermoelectric device may be applied.

A photo detector is another example in which the thermoelectric device according to the embodiment of the present invention is applied to the medical device. Here, the photo detector includes devices such as infrared/ultraviolet detectors, charge coupled device (CCD) sensors, X-ray detectors, thermoelectric thermal reference sources (TTRS), and the like. The Peltier-based thermoelectric device may be applied to cool the photo detector. Accordingly, a wavelength change, an output decrease, and a resolution decrease, and the like due to a temperature increase in the photo detector may be prevented.

Another example in which the thermoelectric device according to the embodiment of the present invention is applied to the medical device includes an immunoassay field, an in vitro diagnostics field, general temperature control and cooling systems, physiotherapy, a liquid chiller system, a blood/plasma temperature control field, and the like. Accordingly, precise temperature control may be performed.

Still another example in which the thermoelectric device according to the embodiment of the present invention is applied to the medical device includes an artificial heart. Accordingly, power may be supplied to the artificial heart.

An example in which the thermoelectric device according to the embodiment of the present invention is applied to the aerospace industry includes a star tracking system, a thermal imaging camera, an infrared/ultraviolet detector, a CCD sensor, the Hubble Space Telescope, a target tracking radar (TTRS), and the like. Accordingly, the temperature of an image sensor may be maintained.

Another example in which the thermoelectric device according to the embodiment of the present invention is applied to the aerospace industry includes a cooling device, a heater, a power generation device, and the like.

In addition, the thermoelectric device according to the embodiment of the present invention may be applied to other industrial fields for power generation, cooling, and warming.

Although preferable embodiments of the present invention are described above, those skilled in the art may variously modify and change the present invention within the scope of the present invention disclosed in the claims which will be described later.

**Claims**

1. A thermoelectric device (100) comprising:

    a first substrate (410);
    a plurality of P-type thermoelectric legs (420) and a plurality of N-type thermoelectric (430) legs alternately disposed on the first substrate (410);
    a second substrate disposed on the plurality of P-type thermoelectric legs (420) and the plurality of N-type thermoelectric legs (430);
    a plurality of first electrodes (450) disposed between the first substrate (410) and the plurality of P-type thermoelectric legs (420) and the plurality of N-type thermoelectric legs (430) and respectively having a pair of P-type thermoelectric leg (420) and N-type thermoelectric leg (430) disposed therein; and
    a plurality of second electrodes (460) disposed between the second substrate and the plurality of P-type thermoelectric legs (420) and the plurality of N-type thermoelectric legs (430) and respectively having a pair of P-type thermoelectric leg (420) and N-type thermoelectric leg (430) disposed therein,
    wherein a pair of P-type solder layer (470) and N-type solder layer (470) and a barrier layer (480) disposed between the pair of P-type solder layer (470) and N-type solder layer (470) are disposed on each of the plurality of first electrodes (450),
    a pair of P-type solder layer (470) and N-type solder layer (470) and a barrier layer (480) disposed between the pair of P-type solder layer (470) and N-type solder layer (470) are disposed on each of the plurality of second electrodes (460),
    each of the P-type thermoelectric legs (420) directly comes into contact with each of the P-type solder layers (470), and
    each of the N-type thermoelectric legs (430) directly comes into contact with each of the N-type solder layers (470),
    **characterized in that**
    a melting point of the barrier layer (480) is greater than a melting point of each of the pair of P-type solder layer (470) and N-type solder layer (470),
    that each of the barrier layers (480) has an insulation property, and
    that an adhesive resin layer (800) is further provided between the first substrate (410) and the plurality of first electrodes (450).

2. The thermoelectric device of claim 1, wherein a height of the barrier layer (480) is greater than a height of each of the pair of P-type solder layer (470) and N-type solder layer (470).

3. The thermoelectric device of claim 2, wherein side surfaces of the barrier layer (480) come into contact with the pair of P-type solder layer (470) and N-type solder layer (470).

4. The thermoelectric device of claim 3, wherein:

    the barrier layer (480) includes a first region (A1) having a first height (h1), and a second region (A2) having a second height (h2) which is lower than the first height (h1);
    at least a portion of the first region (A1) comes into contact with a side surface of each of the pair of P-type solder layer (470) and N-type solder layer (470); and
    the second region (A2) is surrounded by the first region (A1).

5. The thermoelectric device of claim 4, wherein the first height (h1) is 1.01 to 1.2 times the second height (h2).

6. The thermoelectric device of claim 5, wherein an area of the first region (A1) is 0.01% to 10% of an entire area of the barrier layer.

7. The thermoelectric device of claim 1, wherein the barrier layer (480) includes an epoxy resin.

8. The thermoelectric device of claim 1, wherein a plated layer is further disposed on each of the plurality of first electrodes (450) and the plurality of second electrodes (460).

9. The thermoelectric device of claim 8, wherein the barrier layer (480) is directly adhered onto the plated layer.

10. The thermoelectric device of claim 8, wherein the plated layer includes nickel or tin.

11. The thermoelectric device of claim 1, wherein the adhesive resin layer (800) is coated on an entire surface of the first substrate (410).

**12.** The thermoelectric device of claim 1, wherein the adhesive resin layer (800) is coated to be partitioned according to the plurality of first electrodes (450) disposed to be spaced apart from each other.

**13.** The thermoelectric device of claim 2, wherein the height of the barrier layer (480) is 1.1 to 10 times the height of each of the pair of P-type solder layer (470) and N-type solder layer (470).

**Patentansprüche**

**1.** Thermoelektrische Vorrichtung (100), umfassend:

ein erstes Substrat (410);
eine Vielzahl von P-leitenden thermoelektrischen Schenkeln (420) und eine Vielzahl von N-leitenden thermoelektrischen Schenkeln (430), die auf dem ersten Substrat (410) abwechselnd angeordnet sind;
ein zweites Substrat, das auf der Vielzahl von P-leitenden thermoelektrischen Schenkeln (420) und der Vielzahl von N-leitenden thermoelektrischen Schenkeln (430) angeordnet ist;
eine Vielzahl von ersten Elektroden (450), die zwischen dem ersten Substrat (410) und der Vielzahl von P-leitenden thermoelektrischen Schenkeln (420) und der Vielzahl von N-leitenden thermoelektrischen Schenkeln (430) angeordnet sind und die jeweils ein Paar von P-leitenden thermoelektrischen Schenkeln (420) und N-leitenden thermoelektrischen Schenkeln (430) darin angeordnet aufweisen; und
eine Vielzahl von zweiten Elektroden (460), die zwischen dem zweiten Substrat und der Vielzahl von P-leitenden thermoelektrischen Schenkeln (420) und der Vielzahl von N-leitenden thermoelektrischen Schenkeln (430) angeordnet sind und die jeweils ein Paar von P-leitenden thermoelektrischen Schenkeln (420) und N-leitenden thermoelektrischen Schenkeln (430) darin angeordnet aufweisen,
wobei ein Paar von P-leitender Lötschicht (470) und N-leitender Lötschicht (470) und eine Sperrschicht (480), die zwischen dem Paar von P-leitender Lötschicht (470) und N-leitender Lötschicht (470) angeordnet ist, auf jeder der Vielzahl von ersten Elektroden (450) angeordnet sind,
ein Paar von P-leitender Lötschicht (470) und N-leitender Lötschicht (470) und eine Sperrschicht (480), die zwischen dem Paar von P-leitender Lötschicht (470) und N-leitender Lötschicht (470) angeordnet ist, auf jeder der Vielzahl von zweiten Elektroden (460) angeordnet sind,
jeder der P-leitenden thermoelektrischen Schenkel (420) mit jeder der P-leitenden Lötschichten (470) direkt in Kontakt kommt, und jeder der N-leitenden thermoelektrischen Schenkel (430) mit jeder der N-leitenden Lötschichten (470) direkt in Kontakt kommt,
**dadurch gekennzeichnet, dass**
ein Schmelzpunkt der Sperrschicht (480) über einem Schmelzpunkt jedes des Paars von P-leitender Lötschicht (470) und N-leitender-Lötschicht (470) ist,
**dass** jede der Sperrschichten (480) eine isolierende Eigenschaft aufweist, und
**dass** ferner eine Klebeharzschicht (800) zwischen dem ersten Substrat (410) und der Vielzahl von ersten Elektroden (450) bereitgestellt ist.

**2.** Thermoelektrische Vorrichtung nach Anspruch 1, wobei eine Höhe der Sperrschicht (480) über einer Höhe jedes des Paars von P-leitender Lötschicht (470) und N-leitender Lötschicht (470) ist.

**3.** Thermoelektrische Vorrichtung nach Anspruch 2, wobei die Seitenoberflächen der Sperrschicht (480) mit dem Paar von P-leitender Lötschicht (470) und N-leitender Lötschicht (470) in Kontakt kommen.

**4.** Thermoelektrische Vorrichtung nach Anspruch 3, wobei:

die Sperrschicht (480) einen ersten Bereich (A1), der eine erste Höhe (h1) aufweist, und einen zweiten Bereich (A2), der eine zweite Höhe (h2) aufweist, die niedriger als die erste Höhe (h1) ist, einschließt;
mindestens ein Abschnitt des ersten Bereichs (A1) mit einer Seitenoberfläche jedes des Paars von P-leitender Lötschicht (470) und N-leitender Lötschicht (470) in Kontakt kommt; und
der zweite Bereich (A2) von dem ersten Bereich (A1) umgeben ist.

**5.** Thermoelektrische Vorrichtung nach Anspruch 4, wobei die erste Höhe (h1) 1,01 bis 1,2-mal die zweite Höhe (h2) ist.

**6.** Thermoelektrische Vorrichtung nach Anspruch 5, wobei eine Fläche des ersten Bereichs (A1) 0,01 % bis 10 % einer gesamten Fläche der Sperrschicht ist.

**7.** Thermoelektrische Vorrichtung nach Anspruch 1, wobei die Sperrschicht (480) ein Epoxidharz einschließt.

**8.** Thermoelektrische Vorrichtung nach Anspruch 1, wobei ferner auf jeder der Vielzahl von ersten Elektroden (450) und der Vielzahl von zweiten Elektroden (460) eine plattierte Schicht angeordnet ist.

9. Thermoelektrische Vorrichtung nach Anspruch 8, wobei die Sperrschicht (480) auf die plattierte Schicht direkt aufgeklebt ist.

10. Thermoelektrische Vorrichtung nach Anspruch 8, wobei die plattierte Schicht Nickel oder Zinn einschließt.

11. Thermoelektrische Vorrichtung nach Anspruch 1, wobei die Klebeharzschicht (800) auf eine gesamte Oberfläche des ersten Substrats (410) beschichtet ist.

12. Thermoelektrische Vorrichtung nach Anspruch 1, wobei die Klebeharzschicht (800) beschichtet ist, um gemäß der Vielzahl von ersten Elektroden (450) aufgeteilt zu werden, die angeordnet sind, um voneinander beabstandet zu sein.

13. Thermoelektrische Vorrichtung nach Anspruch 2, wobei die Höhe der Sperrschicht (480) 1,1 bis 10-mal die Höhe jedes des Paars von P-leitender Lötschicht (470) und N-leitender Lötschicht (470) ist.

## Revendications

1. Dispositif thermoélectrique (100) comprenant :

un premier substrat (410) ;
une pluralité de pattes thermoélectriques de type P (420) et une pluralité de pattes thermoélectriques de type N (430) disposées en alternance sur le premier substrat (410) ;
un second substrat disposé sur la pluralité de pattes thermoélectriques de type P (420) et la pluralité de pattes thermoélectriques de type N (430) ;
une pluralité de premières électrodes (450) disposées entre le premier substrat (410) et la pluralité de pattes thermoélectriques de type P (420) et la pluralité de pattes thermoélectriques de type N (430) et ayant respectivement une paire de patte thermoélectrique de type P (420) et de patte thermoélectrique de type N (430) ; et
une pluralité de secondes électrodes (460) disposées entre le second substrat et la pluralité de pattes thermoélectriques de type P (420) et la pluralité de pattes thermoélectriques de type N (430) et ayant respectivement une paire de patte thermoélectrique de type P (420) et de patte thermoélectrique de type N (430),
dans lequel une paire de couche de soudure de type P (470) et de couche de soudure de type N (470) et une couche barrière (480) disposée entre la paire de couche de soudure de type P (470) et de couche de soudure de type N (470) sont disposées sur chacune de la pluralité de premières électrodes (450),
une paire de couche de soudure de type P (470) et de couche de soudure de type N (470) et une couche barrière (480) disposée entre la paire de couche de soudure de type P (470) et de couche de soudure de type N (470) sont disposées sur chacune de la pluralité de secondes électrodes (460),
chacune des pattes thermoélectriques de type P (420) entre directement en contact avec chacune des couches de soudure de type P (470), et chacune des pattes thermoélectriques de type N (430) entre directement en contact avec chacune des couches de soudure de type N (470), **caractérisé en ce que**
un point de fusion de la couche barrière (480) est supérieur à un point de fusion de chacune des paires de couche de soudure de type P (470) et de couche de soudure de type N (470), **en ce que** chacune des couches barrières (480) a une propriété d'isolation, et **en ce qu'**une couche de résine adhésive (800) est en outre placée entre le premier substrat (410) et la pluralité de premières électrodes (450).

2. Dispositif thermoélectrique selon la revendication 1, dans lequel une hauteur de la couche barrière (480) est supérieure à une hauteur de chacune des paires de couche de soudure de type P (470) et de couche de soudure de type N (470).

3. Dispositif thermoélectrique selon la revendication 2, dans lequel des surfaces latérales de la couche barrière (480) entrent en contact avec la paire de couche de soudure de type P (470) et de couche de soudure de type N (470).

4. Dispositif thermoélectrique selon la revendication 3, dans lequel :

la couche barrière (480) comporte une première région (A1) ayant une première hauteur (h1) et une seconde région (A2) ayant une seconde hauteur (h2) qui est inférieure à la première hauteur (h1) ;
au moins une partie de la première région (A1) entre en contact avec une surface latérale de chaque paire de couche de soudure de type P (470) et de couche de soudure de type N (470) ; et
la seconde région (A2) est entourée par la première région (A1).

5. Dispositif thermoélectrique selon la revendication 4, dans lequel la première hauteur (h1) est de 1,01 à 1,2 fois la seconde hauteur (h2).

**6.** Dispositif thermoélectrique selon la revendication 5, dans lequel une aire de la première région (A1) est comprise entre 0,01 % et 10 % de l'aire totale de la couche barrière.

**7.** Dispositif thermoélectrique selon la revendication 1, dans lequel la couche barrière (480) comporte une résine époxy.

**8.** Dispositif thermoélectrique selon la revendication 1, dans lequel une couche plaquée est en outre disposée sur chacune de la pluralité de premières électrodes (450) et de la pluralité de secondes électrodes (460).

**9.** Dispositif thermoélectrique selon la revendication 8, dans lequel la couche barrière (480) est directement collée sur la couche plaquée.

**10.** Dispositif thermoélectrique selon la revendication 8, dans lequel la couche plaquée comporte du nickel ou de l'étain.

**11.** Dispositif thermoélectrique selon la revendication 1, dans lequel la couche de résine adhésive (800) est recouverte sur toute la surface du premier substrat (410).

**12.** Dispositif thermoélectrique selon la revendication 1, dans lequel la couche de résine adhésive (800) est revêtue pour être divisée selon la pluralité de premières électrodes (450) disposées de manière à être espacées les unes des autres.

**13.** Dispositif thermoélectrique selon la revendication 2, dans lequel la hauteur de la couche barrière (480) est de 1,1 à 10 fois la hauteur de chacune des paires de couche de soudure de type P (470) et de couche de soudure de type N (470).

【FIG. 1】

(a)

(b)

【FIG. 2】

(a)                              (b)

【FIG. 3】

【FIG. 4】

【FIG. 5】

450
470
480
470
410

【FIG. 6】

```
┌─────────────────────────────────────────────┐
│        DISPOSE ELECTRODES ON SUBSTRATE        │～S600
└─────────────────────────────────────────────┘
                      │
                      ▼
┌─────────────────────────────────────────────┐
│        PRINT BARRIER LAYER ON ELECTRODES      │～S610
└─────────────────────────────────────────────┘
                      │
                      ▼
┌─────────────────────────────────────────────┐
│         DISPOSE SOLDER ON ELECTRODES          │～S620
└─────────────────────────────────────────────┘
                      │
                      ▼
┌─────────────────────────────────────────────┐
│                 MOUNT LEGS                    │～S630
└─────────────────────────────────────────────┘
                      │
                      ▼
┌─────────────────────────────────────────────┐
│                  REFLOW                       │～S640
└─────────────────────────────────────────────┘
```

【FIG. 7】

【FIG. 8】

(a)

(b)

【FIG. 9】

【FIG. 10】

【FIG. 11】

【FIG. 12】

110
190
120

【FIG. 13】

【FIG. 14】

【FIG. 15】

【FIG. 16】

【FIG. 17】

【FIG. 18】

【FIG. 19】

【FIG. 20】

| |
|---|
| FORM PLURALITY OF GROOVES IN EDGE OF FIRST SUBSTRATE — S1100 |
| COAT ADHESION LAYER ON FIRST SUBSTRATE — S1110 |
| DISPOSE FIRST ELECTRODE ARRAY ON ADHESION LAYER — S1120 |
| DISPOSE ELECTRODE FIXING MEMBER ON FIRST ELECTRODE ARRAY AND THEN PRESSURIZE ELECTRODE FIXING MEMBER — S1130 |

【FIG. 21】

【FIG. 22】

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 20120081777 A

- US 2012167937 A1